# FASCICULE DE BREVET EUROPEEN

(11) **EP 1 542 130 B1**
(45) Date de publication et mention de la délivrance du brevet: **11.04.2007**
(21) Numéro de dépôt: 04029018.1
(22) Date de dépôt: 08.12.2004
(51) Int. Cl.: G06F 12/06, G11C 7/10

(54) **Mémoire série comprenant des moyens d'intégration dans un plan mémoire étendu**
Serieller Speicher mit Mitteln zur Integration eines erweiterten Speicherfeldes
Serial memory comprising an extended memory space integration means

(30) Priorité: 12.12.2003 FR 0314621; 12.12.2003 FR 0314628; 12.12.2003 FR 0314622
(43) Date de publication de la demande: 15.06.2005
(73) Titulaire: STMicroelectronics S.A., 92210 Montrouge (FR)
(72) Inventeur: Zink, Sébastien, 13090 Aix-en-Provence (FR); Cavalieri, Paola, 13790 Rousset (FR); Leconte, Bruno, 13790 Rousset (FR); Devin, Jean, 13100 Le Tholonet (FR); Maugain, François, 13530 Trets (FR)
(74) Mandataire: Marchand, André

(56) Documents cités:
- US-A- 5 303 201
- US-A- 5 895 480
- HIROTADA KURIYAMA: "AN 8-NS 4-MB SERIAL ACCESS MEMORY" IEEE JOURNAL OF SOLID-STATE CIRCUITS, IEEE INC. NEW YORK, US, vol. 26, no. 4, 1 avril 1991 (1991-04-01), pages 502-506, XP000216719 ISSN: 0018-9200

## Description

La présente invention concerne les mémoires série sur microplaquette de silicium, et plus particulièrement la réalisation d'un plan mémoire étendu par juxtaposition d'une pluralité de mémoires série.

Les mémoires intégrées sur microplaquette de silicium présentent un plan mémoire intégré de taille limitée, généralement inférieure à l'espace mémoire que nécessitent certaines applications. Par exemple, les périphériques informatiques tels les imprimantes nécessitent des mémoires de grande capacité pour stocker de gros volumes de données. De ce fait, il est habituel de regrouper plusieurs microplaquettes de silicium pour former des plans mémoire étendus constitués par la juxtaposition des plans mémoire intégrés présents dans chacune des mémoires. Un tel regroupement consiste généralement en un empilement de microplaquettes de silicium dans un même boîtier ou un empilement de boîtiers comprenant chacun une microplaquette de silicium.

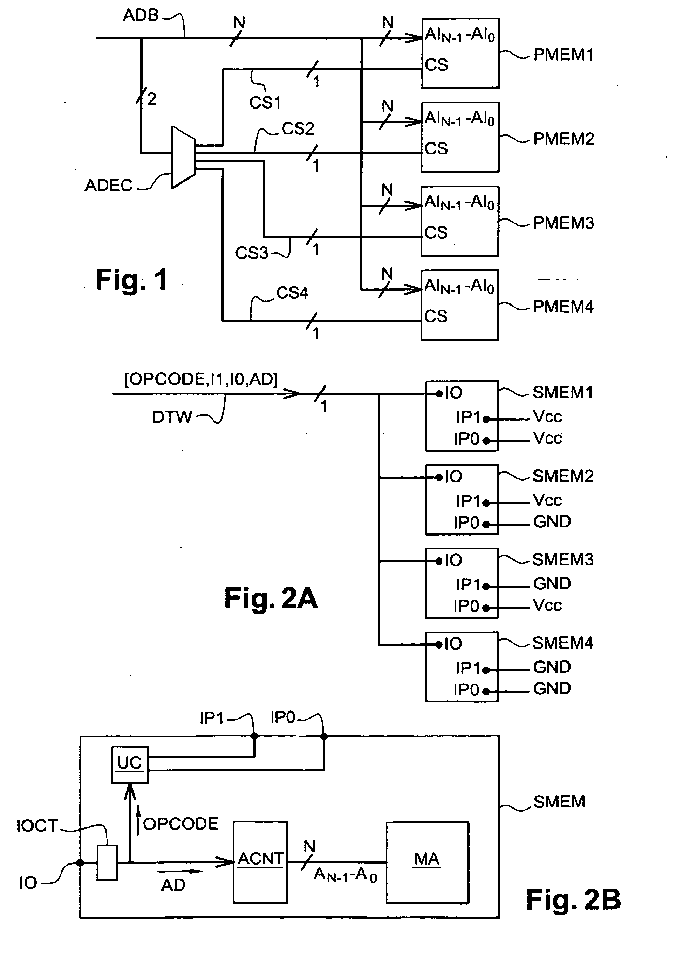

Les figures 1 et 2A, 2B illustrent deux procédés classiques permettant de réaliser un plan mémoire étendu, respectivement avec des mémoires de type parallèle et des mémoires série.

Sur la figure 1, quatre mémoires identiques PMEM1, PMEM2 PMEM3, PMEM4 de type à entrée/sortie parallèle sont regroupées pour obtenir un plan mémoire étendu. Les mémoires comprennent chacune un plan mémoire intégré adressable sous N bits (non représenté). Chaque mémoire comporte N entrées d'adresse AI₀-AI_{N-1} en parallèle, connectées aux N fils d'adresse de plus faible poids d'un bus d'adresse ADB. Le bus d'adresse comprend N+2 fils d'adresse, nécessaires à l'adressage du plan mémoire étendu dont la taille est ici quatre fois celle des plans mémoire intégrés dans les microplaquettes de silicium. La sélection de chaque mémoire au sein du plan mémoire étendu est faite au moyen d'une entrée de sélection CS ("Chip Select") prévue sur chaque microplaquette de silicium. A cet effet, les deux fils de plus fort poids du bus d'adresse ADB sont appliqués à un décodeur d'adresse ADEC qui fournit quatre fils de sélection CS1, CS2, CS3, CS4, chaque fil de sélection étant connecté à l'entrée CS d'une mémoire.

Cet exemple montre que la réalisation d'un plan mémoire étendu au moyen de circuits intégrés à entrées parallèles entraîne une démultiplication rédhibitoire des fils d'interconnexion afin de pouvoir sélectionner individuellement les mémoires au sein du plan mémoire étendu.

La figure 2A concerne plus spécifiquement le domaine technique de l'invention et représente un plan mémoire étendu réalisé avec quatre mémoires identiques SMEM1, SMEM2, SMEM3, SMEM4 à entrée/sortie série, ou mémoires série, dont la structure est représentée schématiquement en figure 2B.

Chaque mémoire SMEM comprend une entrée/sortie série IO, un circuit d'entrée/sortie IOCT, une unité centrale UC, un compteur d'adresse ACNT de N bits et un plan mémoire intégré MA adressable sous N bits (fig. 2B). Le circuit IOCT est relié à l'entrée/sortie série 10 et transforme des données reçues sous forme série en données parallèles, et inversement. Chaque entrée/sortie série IO est connectée à un fil de données DTW (fig. 2A) commun à toutes les mémoires, qui véhicule à la fois des commandes, des adresses et des données sous forme série. Chaque mémoire comprend également deux entrées IP1, IPO dont le potentiel électrique est ajusté de manière à attribuer à chaque mémoire une adresse de poids fort déterminée. Par exemple, les deux entrées IP1, IPO de la mémoire SMEM1 sont portées à une tension d'alimentation Vcc pour attribuer à la mémoire l'adresse de poids fort "11", les entrées IP1, IPO de la mémoire SMEM2 sont portées respectivement à la tension Vcc et à la masse (GND) pour attribuer à la mémoire l'adresse de poids fort "10", les entrées IP1, IPO de la mémoire SMEM3 sont portées à la masse et à la tension Vcc pour attribuer à la mémoire l'adresse de poids fort "01" et les entrées IP1, IPO de la mémoire SMEM4 sont portées à la masse pour attribuer à la mémoire l'adresse de poids fort "00".

La sélection de chaque mémoire au sein du plan mémoire étendu est faite en envoyant aux mémoires des commandes du type [OPCODE, I1, I0, AD] comprenant un code opération OPCODE, deux bits Il, 10 formant une adresse de poids fort et une adresse AD de N bits formant une adresse de poids faible, l'adresse de poids fort formant avec l'adresse AD une adresse étendue. L'unité centrale de chaque mémoire exécute les codes opération OPCODE présents dans les commandes reçues si l'adresse de poids fort I1 10 correspond à l'adresse de poids fort IP1 IP0 attribuée à la mémoire. Dans le cas d'une commande de lecture, le compteur d'adresse ACNT applique au plan mémoire MA les N bits d'adresse A_{N-1}-A₀ présents dans la commande, tandis que l'unité centrale applique un signal de lecture au plan mémoire.

Les brevets US 5 303 201 et US 5 895 480 décrivent des mémoires du type précité, dans lesquelles le compteur d'adresse (un tampon d'adresse dans US 5 895 480) est un compteur d'adresse étendu (ou un tampon d'adresse étendue) pouvant recevoir une adresse étendue au lieu de ne recevoir que l'adresse de poids faible. Le fonctionnement de ces mémoires est sensiblement identique à celui de la mémoire décrite ci-dessus, en ce que l'adresse de poids fort reçue par le compteur ou tampon d'adresse est comparée à l'adresse de poids fort attribuée à la mémoire, et en ce qu'une commande de lecture n'est pas exécutée si l'adresse de poids fort présente dans une adresse étendue n'est pas identique à l'adresse de poids fort attribuée à la mémoire.

En résumé, le procédé classique d'obtention d'un plan mémoire étendu consiste à prévoir des mémoires capables de "s'auto-identifier" sur réception d'une commande comprenant une adresse étendue, et de ne pas exécuter la commande si l'adresse de poids fort incluse dans l'adresse étendue n'est pas identique à l'adresse de poids fort attribuée à la mémoire.

Ce procédé est avantageux en ce qui concerne le nombre d'interconnexions électriques, mais le plan mémoire étendu obtenu ne présente pas de caractère unitaire, par exemple en ce qui concerne l'exécution d'une commande de lecture continue. Ainsi, une lecture continue du plan mémoire étendu nécessite tout d'abord l'envoi à la première mémoire SMEM1 d'une commande de lecture continue de son plan mémoire intégré, une telle commande comprenant le code opération de la commande, l'adresse de poids fort 1,1 de la mémoire SMEM1, et l'adresse de poids faible AD0 désignant la zone mémoire où la lecture continue doit être initialisée dans le plan mémoire intégré. Des commandes similaires ayant des bits d'identification appropriés doivent ensuite être envoyées aux autres mémoires, soit au total quatre commandes pour lire l'ensemble du plan mémoire étendu.

Ainsi, un objectif général de la présente invention est de prévoir un procédé et une structure de mémoire série qui permettent de réaliser un plan mémoire étendu ayant un caractère unitaire, c'est-à-dire se comportant, vu de l'extérieur, comme une mémoire unique comprenant un plan mémoire de grande taille.

Un objectif plus particulier de l'invention est de prévoir un plan mémoire étendu présentant un caractère unitaire en ce qui concerne l'exécution d'une commande de lecture continue du plan mémoire.

Un objectif plus particulier de l'invention est de prévoir un plan mémoire étendu présentant un caractère unitaire en ce qui concerne l'exécution de commandes particulières visant à lire des registres spéciaux qui sont généralement prévus dans les mémoires série, par exemple des registres d'état ou des registres d'identification.

Un objectif plus particulier de l'invention est de prévoir un plan mémoire étendu présentant un caractère unitaire en ce qui concerne la protection du plan mémoire étendu en lecture et en écriture lorsqu'une mémoire est en train de réaliser une opération d'écriture.

Au moins un objectif de l'invention est atteint par la prévision d'une mémoire sur microplaquette de silicium, comprenant une entrée/sortie série et un plan mémoire intégré, des moyens pour mémoriser une adresse de poids fort attribuée à la mémoire au sein d'un plan mémoire étendu adressable avec une adresse étendue comprenant une adresse de poids faible et une adresse de poids fort, un compteur d'adresse étendue pour mémoriser une adresse étendue reçue sur l'entrée/sortie série de la mémoire, et appliquer l'adresse de poids faible au plan mémoire intégré, des moyens pour comparer l'adresse de poids fort de l'adresse étendue avec l'adresse de poids fort attribuée à la mémoire, et des moyens pour empêcher l'exécution d'une commande de lecture ou d'écriture du plan mémoire intégré si l'adresse de poids fort de l'adresse étendue est différente de l'adresse de poids fort attribuée à la mémoire, dans laquelle les moyens pour empêcher l'exécution d'une commande de lecture du plan mémoire sont agencés pour laisser la mémoire effectuer la lecture de son plan mémoire intégré tout en empêchant les données lues dans le plan mémoire intégré d'être appliquées sur l'entrée/sortie série de la mémoire.

Selon un mode de réalisation, la mémoire comprend un circuit tampon de sortie pour fournir sur l'entrée/sortie série de la mémoire des données lues dans le plan mémoire intégré, et des moyens pour fournir un signal de blocage du circuit tampon de sortie si l'adresse de poids fort de l'adresse étendue est différente de l'adresse de poids fort attribuée à la mémoire.

Selon un mode de réalisation, la mémoire comprend un circuit de décalage temporel pour décaler dans le temps l'application du signal de blocage au circuit tampon de sortie si, au moment où le signal de blocage passe à une valeur active, le circuit tampon de sortie est en train de fournir sur l'entrée/sortie série les bits d'une donnée lue dans le plan mémoire intégré avant que le signal de blocage ne passe à la valeur active.

Selon un mode de réalisation, la mémoire comprend une unité centrale pour exécuter une commande de lecture continue du plan mémoire étendu en incrémentant ou décrémentant continuellement le compteur d'adresse étendue y compris lorsque l'adresse de poids fort de l'adresse étendue est différente de l'adresse de poids fort attribuée à la mémoire, jusqu'à l'arrêt de l'exécution de la commande de lecture continue.

Selon un mode de réalisation, l'unité centrale est agencée pour lire continuellement le plan mémoire intégré pendant l'exécution d'une commande de lecture continue, y compris lorsque l'adresse de poids fort de l'adresse étendue est différente de l'adresse de poids fort attribuée à la mémoire.

Selon un mode de réalisation, la mémoire comprend des moyens pour mémoriser une information sur un nombre K de bits que comprend l'adresse de poids fort de l'adresse étendue, K étant une variable comprise entre 0 et Kmax, Kmax étant non nul, un compteur d'adresse étendue comprenant N+Kmax cellules de comptage, N étant le nombre de bits de l'adresse de poids faible, et des moyens pour mémoriser Kmax bits de référence parmi lesquels K bits de référence représentent l'adresse de poids fort attribuée à la mémoire.

Selon un mode de réalisation, la mémoire comprend un registre de configuration pour mémoriser Kmax drapeaux correspondant par leur nombre et leur rang aux bits que peut contenir au maximum l'adresse de poids fort de l'adresse étendue, chaque drapeau présentant une valeur logique déterminée si un bit de rang correspondant est présent dans l'adresse de poids fort de l'adresse étendue, de sorte que le nombre de drapeaux ayant la valeur logique déterminée définit le nombre de bits présents dans l'adresse de poids fort de l'adresse étendue.

Selon un mode de réalisation, la mémoire comprend un registre de configuration pour mémoriser un nombre binaire codé donnant une indication sur la taille du plan mémoire étendu, et un circuit de décodage fournissant, à partir du nombre binaire codé, Kmax drapeaux correspondant par leur nombre et leur rang aux bits que peut contenir au maximum l'adresse de poids fort de l'adresse étendue, chaque drapeau présentant une valeur logique déterminée si le bit de rang correspondant est présent dans l'adresse de poids fort de l'adresse étendue, de sorte que le nombre de drapeaux ayant la valeur logique déterminée définit le nombre de bits présents dans l'adresse de poids fort de l'adresse étendue.

Selon un mode de réalisation, la mémoire comprend des moyens pour désactiver des cellules de comptage du compteur d'adresse étendue en fonction de l'information sur le nombre de bits que comprend l'adresse de poids fort de l'adresse étendue, de manière que le compteur ne comprenne que N+K cellules de comptage actives.

Selon un mode de réalisation, les moyens pour comparer l'adresse de poids fort de l'adresse étendue avec l'adresse de poids fort attribuée à la mémoire comprennent un comparateur et des moyens pour inhiber des entrées du comparateur en fonction de l'information sur le nombre de bits que comprend l'adresse de poids fort d'une adresse étendue, de manière que le comparateur ne comprenne que K entrées actives.

Selon un mode de réalisation, la mémoire comprend un contact de disponibilité/occupation pouvant être forcé depuis l'extérieur à un potentiel électrique déterminé, et des moyens internes pour forcer au potentiel électrique déterminé le contact de disponibilité/occupation, pendant une opération d'effacement ou de programmation du plan mémoire intégré, la mémoire étant agencée pour ne pas exécuter une commande de lecture ou d'écriture lorsque le potentiel électrique du contact de disponibilité/occupation présente le potentiel déterminé.

Selon un mode de réalisation, la mémoire comprend des contacts spécifiques permettant de configurer des bits de référence représentant l'adresse de poids fort attribuée à la mémoire, en appliquant des potentiels électriques déterminés sur les contacts spécifiques.

La présente invention concerne également un plan mémoire étendu comprenant une combinaison d'au moins deux mémoires selon l'invention, dans lequel les entrées/sorties série de chaque mémoire sont interconnectées.

La présente invention concerne également un plan mémoire étendu comprenant une combinaison d'au moins deux mémoires selon l'invention, dans lequel les entrées/sorties série de chaque mémoire sont interconnectées et les contacts de disponibilité/occupation de chaque mémoire sont interconnectés.

La présente invention concerne également un procédé pour la réalisation d'un plan mémoire étendu adressable avec une adresse étendue comprenant une adresse de poids faible et une adresse de poids fort, le plan mémoire étendu comprenant une pluralité de mémoires série intégrées sur microplaquettes de silicium, chaque mémoire comprenant une entrée/sortie série et un plan mémoire intégré adressable avec l'adresse de poids faible, les entrées/sorties série des mémoires étant interconnectées, le procédé comprenant les étapes consistant à prévoir, dans chaque mémoire, des moyens pour mémoriser une adresse de poids fort attribuée à la mémoire au sein du plan mémoire étendu, prévoir, dans chaque mémoire, un compteur d'adresse étendue pour mémoriser une adresse étendue, attribuer une adresse de poids fort à chaque mémoire, appliquer aux mémoires une commande de lecture ou d'écriture comprenant une adresse étendue, et empêcher l'exécution d'une commande de lecture ou d'écriture dans chaque mémoire ayant une adresse de poids fort attribuée qui est différente de l'adresse de poids fort présente dans la commande de lecture ou d'écriture, et dans lequel l'étape- consistant à empêcher l'exécution d'une commande de lecture dans une mémoire comprend le fait de laisser la mémoire lire son plan mémoire intégré tout en empêchant les données lues dans le plan mémoire intégré d'être appliquées sur l'entrée/sortie série de la mémoire.

Selon un mode de réalisation, le procédé comprend les étapes consistant à prévoir, dans chaque mémoire, un contact de disponibilité/occupation, prévoir, dans chaque mémoire, des moyens pour forcer à un potentiel électrique déterminé le contact de disponibilité/occupation, pendant une opération d'effacement ou de programmation du plan mémoire intégré, interconnecter les contacts de disponibilité/occupation des mémoires, et configurer chaque mémoire pour qu'elle n'exécute pas une commande de lecture ou d'écriture lorsque le potentiel électrique du contact de disponibilité/occupation présente le potentiel déterminé.

Selon un mode de réalisation, chaque mémoire comprend un circuit tampon de sortie pour fournir sur l'entrée/sortie série de la mémoire des données lues dans le plan mémoire intégré, et l'étape consistant à empêcher des données lues dans le plan mémoire intégré d'être fournies sur l'entrée/sortie de la mémoire comprend l'application d'un signal de blocage au circuit tampon de sortie de la mémoire.

La présente invention concerne également un procédé pour la réalisation d'un plan mémoire étendu pouvant répondre à une commande de lecture continue du plan mémoire, comprenant les étapes consistant à appliquer aux mémoires une commande de lecture étendue comportant une adresse étendue de commencement de lecture, et incrémenter ou décrémenter continuellement le compteur d'adresse étendue de chaque mémoire, y compris lorsque les bits d'adresse de poids fort de l'adresse étendue sont différents de l'adresse de poids fort attribuée à la mémoire, jusqu'à l'arrêt de l'exécution de la commande de lecture continue.

Selon un mode de réalisation, le plan mémoire intégré de chaque mémoire est lu continuellement pendant l'exécution d'une commande de lecture continue, y compris lorsque l'adresse de poids fort de l'adresse étendue est différente de l'adresse de poids fort attribuée à la mémoire.

Selon un mode de réalisation, le procédé comprend la prévision, dans chaque mémoire, de moyens pour mémoriser une information sur le nombre K de bits de poids fort que peut comprendre au maximum l'adresse de poids fort de l'adresse étendue, K étant une variable comprise entre 0 et Kmax, Kmax étant non nul.

La présente invention concerne également un procédé pour la réalisation d'un plan mémoire étendu de taille variable adressable au moyen d'une adresse étendue pouvant aller de N bits à N+Kmax bits, sans modifier l'architecture des mémoires composant le plan mémoire étendu, N étant le nombre de bits de l'adresse de poids faible, le procédé comprenant des étapes consistant à prévoir, dans chaque mémoire, un compteur d'adresse étendue comprenant N+Kmax cellules de comptage, prévoir, dans chaque mémoire, des moyens pour mémoriser Kmax bits de référence, et attribuer à chaque mémoire au moins K bits de référence formant une adresse de poids fort.

Selon un mode de réalisation, le procédé comprend la désactivation de cellules de comptage du compteur d'adresse étendue en fonction de l'information sur le nombre K, de manière que le compteur ne comprenne que N+K cellules de comptage actives.

Selon un mode de réalisation, seulement K bits de référence sont comparés avec K bits d'adresse de poids fort présents dans le compteur, sans tenir compte des Kmax-K autres bits d'adresse présents dans le compteur.

Selon un mode de réalisation, l'information sur le nombre K est fournie aux mémoires sous la forme d'un nombre binaire codé donnant une indication sur la taille du plan mémoire étendu.

Selon un mode de réalisation, le procédé comprend la prévision de contacts spécifiques dans chaque mémoire et la configuration de l'adresse de poids fort attribuée à chaque mémoire en appliquant des potentiels électriques déterminés sur les contacts spécifiques.

Ces objets, caractéristiques et avantages ainsi que d'autres de la présente invention seront exposés plus en détail dans la description suivante d'une mémoire selon l'invention, faite à titre non limitatif en relation avec les figures jointes parmi lesquelles :
- la figure 1 précédemment décrite représente un plan mémoire étendu comprenant des mémoires de type parallèle,
- les figures 2A, 2B précédemment décrites représentent respectivement un plan mémoire étendu comprenant des mémoires série classiques et la structure de ces mémoires série,
- la figure 3 représente un plan mémoire étendu comprenant des mémoires série selon l'invention, et représente schématiquement la structure de l'une de ces mémoires série,
- la figure 4 représente sous forme de blocs un exemple de réalisation d'une mémoire série selon l'invention,
- la figure 5A représente un premier exemple de réalisation d'un compteur d'adresse étendue représenté sous forme de bloc en figure 4,
- la figure 5B représente un premier exemple de réalisation d'un comparateur représenté sous forme de bloc en figure 4,
- la figure 6A représente un second exemple de réalisation du compteur d'adresse étendue représenté sous forme de bloc en figure 4,
- la figure 6B représente un second exemple de réalisation du comparateur représenté sous forme de bloc en figure 4,
- les figures 7A à 7J sont des chronogrammes représentant des signaux de comptage et des signaux de données et illustrant le fonctionnement d'un plan mémoire étendu selon l'invention en réponse à une commande de lecture continue.

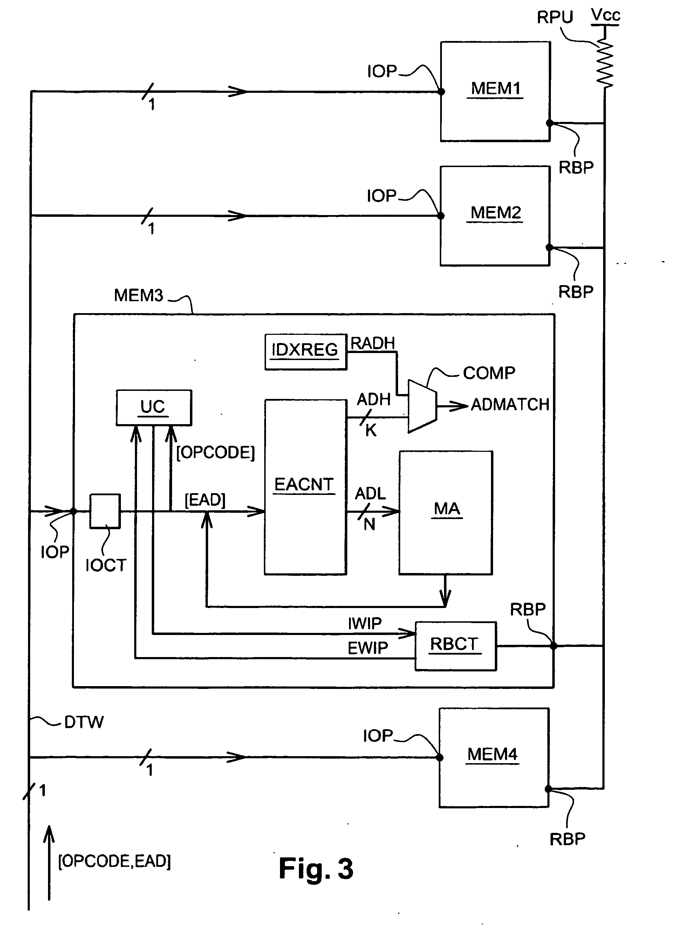

La figure 3 représente un plan mémoire étendu comprenant quatre mémoires série MEM1, MEM2, MEM3, MEM4 selon l'invention, intégrées sur des microplaquettes de silicium. Chaque mémoire comprend classiquement un contact d'entrée/sortie série IOP (In/Out Pad), un circuit d'entrée/sortie IOCT assurant la conversion des données reçues sous forme série en données parallèles, et inversement, un plan mémoire intégré MA adressable sous N bits, et une unité centrale UC à logique câblée ou à microprocesseur. On supposera ici et dans ce qui suit, dans un souci de simplicité de l'exposé, que les plans mémoire intégrés de chaque mémoire sont identiques et que le nombre N de bits d'adresse nécessaire à la lecture ou à l'écriture d'une donnée dans chacun des plans mémoire intégrés est identique pour chaque mémoire.

Les mémoires MEM1 à MEM4 ont leurs contacts IOP respectifs reliés à un fil de données DTW commun. Ce fil de données appartient à un bus de données série pouvant comprendre des fils de contrôle comme des fils d'horloge, d'alimentation, de masse... qui ne sont pas représentés ici.

Selon l'invention, les commandes de lecture ou d'écriture envoyées aux mémoires via le fil DTW comprennent un code opération OPCODE, une adresse EAD, et éventuellement une donnée DT (pour les commandes d'écriture de données), soit :
[OPCODE, EAD] (lecture)
   ou
[OPCODE, EAD, DT] (écriture)

L'adresse EAD est une adresse étendue comprenant un nombre N+K de bits d'adresse qui est supérieur au nombre N de bits d'adresse que nécessite l'adressage du plan mémoire intégré de chaque mémoire, N+K étant au moins égal au nombre de bits d'adresse que nécessite l'adressage du plan mémoire étendu considéré dans son ensemble. L'adresse étendue EAD comprend ainsi N bits d'adresse de poids faible A_{N-1}-A₀ formant une adresse de pois faible ADL destinée à sélectionner une zone mémoire dans l'un des plans mémoire intégrés, généralement un mot binaire, et K bits d'adresse de poids fort A_{N+K-1}, A_{N+K-2},...A_{N} formant une adresse de poids fort ADH permettant de désigner l'une des mémoires.

Dans l'exemple représenté, K est égal à 2 car le plan mémoire étendu comprend quatre mémoires série. Les commandes comportent ainsi des adresses de N+2 bits. L'adresse ADL comprend des bits d'adresse de poids faible A_{N-1}-A₀ et l'adresse ADH comprend 2 bits d'adresse de poids fort A_{N+1}, A_{N}.

Chaque mémoire comprend un compteur d'adresse étendue EACNT de N+K bits, ici N+2 bits, un comparateur COMP ayant deux fois K entrées (2*K), ici 4 entrées, et un moyen de mémorisation d'une adresse de poids fort de référence RADH attribuée à la mémoire, qui représente l'adresse de la mémoire au sein du plan mémoire étendu, plus précisément l'adresse du plan mémoire intégré de la mémoire au sein du plan mémoire étendu.

Ce moyen de mémorisation est par exemple un registre d'indexation IDXREG comprenant K bits de référence R_{K-1}, R_{K-2}, ... R₀, ici deux bits R1, R0, représentant l'adresse RADH. Par exemple, le registre IDXREG de la mémoire MEM1 comprend les bits de référence "00" , le registre IDXREG de la mémoire MEM2 comprend les bits de référence "01", le registre IDXREG de la mémoire MEM3 comprend les bits de référence "10" et le registre IDXREG de la mémoire MEM4 comprend les bits de référence "11".

Lorsqu'une commande comprenant une adresse étendue est envoyée sur le fil de données DTW, chaque mémoire reçoit la commande et applique le code opération OPCODE à son unité centrale UC, et enregistre l'adresse étendue EAD dans son compteur d'adresse étendue EACNT. L'adresse ADL formée par les N premiers bits A_{N-1}-A₀ de l'adresse EAD mémorisée par le compteur, est appliquée au plan mémoire MA tandis que l'adresse ADH, formée par les K bits d'adresse de poids fort de l'adresse EAD, ici les bits A_{N+1}, A_{N}, est appliquée sur K premières entrées du comparateur COMP, ici deux entrées. Ce dernier reçoit sur K autres entrées, ici deux entrées, les bits de référence R_{K-1}-R₀, ici les bits R1, R0.

La sortie du comparateur fournit un signal ADMATCH qui est par exemple à 1 lorsque les bits de poids fort de l'adresse étendue reçue sont identiques à l'adresse de poids fort attribuée à la mémoire, c'est-à-dire identiques aux bits de référence. Le signal ADMATCH est utilisé pour empêcher les mémoires qui ne sont pas concernées par l'adresse étendue d'exécuter la commande reçue, qu'il s'agisse d'une commande de lecture ou d'une commande d'écriture (quand les plans mémoire intégrés sont accessibles en écriture).

La non-exécution d'une commande d'écriture est obtenue classiquement en bloquant l'exécution du code opération par l'unité centrale UC, en ce qui concerne les commandes d'écriture.

Selon l'invention, la non-exécution d'une commande de lecture est obtenue en laissant l'unité centrale de chaque mémoire exécuter l'opération de lecture tout en empêchant les données lues d'être appliquées sur le contact d'entrée/sortie série IOP. Cette méthode permet avantageusement d'assurer une lecture continue du plan mémoire étendu, car elle permet de laisser l'unité centrale de chaque mémoire lire en permanence son plan mémoire intégré, et de fournir les données lues lorsque le signal ADMATCH passe à 1.

Selon un autre aspect de l'invention, chaque mémoire comprend un contact de disponibilité/occupation RBP (Ready/Busy Pad) et un circuit RBCT de gestion du contact RBP. Les contacts RBP des mémoires sont interconnectés et sont portés par défaut à un potentiel haut, ici une tension d'alimentation Vcc, par l'intermédiaire d'une résistance tire-haut RPU de forte valeur. La résistance RPU est ici externe aux mémoires, mais peut également être interne à chaque mémoire, c'est-à-dire être intégrée sur les microplaquettes de silicium.

Le circuit RBCT reçoit un signal IWIP (Internal Write In Progress) émis par l'unité centrale, et fournit à l'unité centrale un signal EWIP (External Write In Progress). Le signal IWIP est mis à 1 par l'unité centrale pendant une opération d'écriture du plan mémoire intégré (effacement et/ou programmation). Lorsque le signal IWIP passe à 1, le circuit RBCT force le contact RBP à un potentiel bas, par exemple le potentiel de masse. Par ailleurs le circuit RBCT met à 1 le signal EWIP lorsqu'il détecte le potentiel bas, ici le potentiel de masse, sur le contact RBP, y compris lorsque le signal IWIP est à 0. Le fait que le signal EWIP soit à 1 alors que le signal IWIP est à 0 signifie que le potentiel de masse sur le contact RBP est imposé par une autre mémoire. Le signal EWIP permet ainsi à l'unité centrale de savoir qu'une mémoire du plan mémoire étendu est en train d'effectuer une opération d'écriture dans le plan mémoire qui lui est propre. L'unité centrale refuse alors d'exécuter une commande de lecture ou d'écriture pouvant éventuellement être reçue sur le contact d'entrée/sortie IOP, tant que l'écriture en cours n'est pas terminée.

Ainsi, lorsqu'une mémoire exécute une opération d'écriture, les autres mémoires en sont informées par le passage à 0 de leur contact RBP, qui entraîne le passage à 1 du signal EWIP. Les unités centrales de ces mémoires refusent alors d'exécuter des commandes en lecture ou en écriture. Cet aspect de l'invention permet de conférer au plan mémoire étendu un caractère unitaire en écriture, puisque celui-ci se comporte alors, vu de l'extérieur, comme une mémoire unique. En effet, une mémoire unique ne peut exécuter simultanément une opération d'écriture et de lecture de son plan mémoire. De même, une mémoire unique ne peut exécuter simultanément deux commandes d'écriture dans deux zones différentes de son plan mémoire. C'est donc le comportement d'une mémoire unique qui est recréé au sein du plan mémoire étendu, considéré comme un tout indivisible.

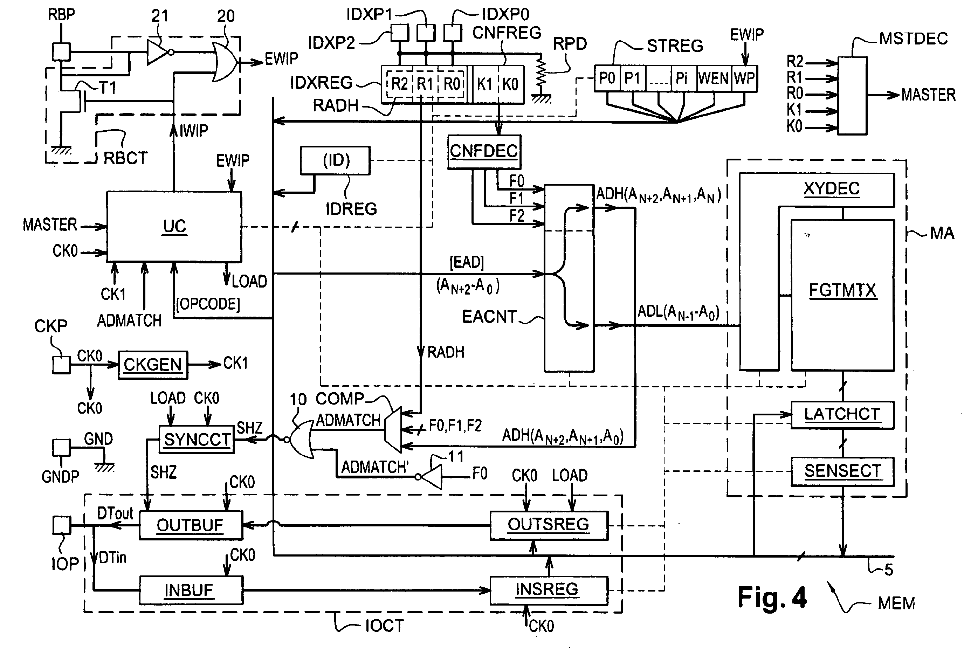

On décrira maintenant en relation avec la figure 4 un mode de réalisation détaillé d'une mémoire série mettant en oeuvre les divers aspects de l'invention mentionnés ci-dessus, ainsi que d'autres qui seront décrits par la suite.

### Aspects généraux de la mémoire

La mémoire MEM représentée en figure 4 comprend les éléments décrits plus haut, à savoir :,
- le contact IOP formant l'entrée/sortie série de la mémoire,
- le contact de disponibilité/occupation RBP,
- le circuit d'entrée/sortie IOCT,
- le circuit RBCT de gestion du contact RBP,
- l'unité centrale UC,
- le compteur d'adresse étendue EACNT,
- le plan mémoire MA adressable sous N bits,
- le registre d'indexation IDXREG, et
- le comparateur COMP.
La mémoire comprend également :
- un bus de données interne 5 de type parallèle,
- un contact de masse GNDP,
- un contact d'horloge CKP recevant un signal d'horloge CK0,
- un circuit d'horloge CKGEN,
- un circuit de synchronisation SYNCCT, et
- deux registres spéciaux, ici un registre d'état STREG (Statuts Register) et un registre d'identification IDREG.

Le circuit d'entrée/sortie comprend un tampon d'entrée INBUF ayant une entrée et une sortie série, un registre à décalage INSREG ayant une entrée série et une sortie parallèle, un tampon de sortie OUTBUF ayant une entrée et une sortie série, et un registre à décalage OUTSREG ayant une entrée parallèle et une sortie série. Le tampon INBUF a son entrée reliée au contact IOP et sa sortie série reliée à l'entrée série du registre INSREG, dont la sortie est reliée au bus de données 5. Le registre OUTSREG a son entrée reliée au bus de données 5. Sa sortie est reliée à l'entrée du tampon OUTBUF dont la sortie est reliée au contact IOP.

Le plan mémoire MA comprend une matrice de cellules mémoire FGTMTX, par exemple une matrice de transistors à grille flottante, un décodeur de ligne et de colonne XYDEC, un circuit de programmation LATCHCT comprenant des verrous haute tension dont les entrées sont reliées au bus 5, et un circuit de lecture SENSECT comprenant des amplificateurs de lecture dont les sorties sont reliées au bus 5.

Les registres spéciaux STREG et IDREG sont accessibles en lecture et en écriture via le bus de données 5. Le registre IDREG comprend par exemple un identifiant unique ID de la microplaquette de silicium. Le registre d'état STREG comprend par exemple des bits P0, P1,...Pi de protection en écriture de fractions (parties) du plan mémoire, un bit WEN de protection générale en écriture (Write Enable), ainsi qu'un bit WP représentatif de la valeur courante du signal EWIP, et de façon générale toute donnée utile à la gestion d'une mémoire connue de l'homme de l'art.

L'unité centrale contrôle les divers éléments de la mémoire, les liaisons de contrôle entre l'unité centrale et ces divers éléments étant représentées schématiquement par un trait pointillé. L'unité centrale contrôle notamment les divers registres en lecture et/ou écriture, contrôle en lecture et écriture le plan mémoire MA et ses éléments constitutifs, contrôle le compteur d'adresse étendue EACNT pour le chargement de l'adresse étendue et/ou pour l'incrémentation ou la décrémentation du compteur, lors de l'exécution de commandes de lecture continue, contrôle le chargement des registres à décalage, etc..

Le générateur d'horloge CKGEN fournit un signal d'horloge CK1 qui est un sous-multiple du signal CK0. Le signal CK0 est un signal d'horloge bit tandis que le signal CK1 est un signal d'horloge mot, dont la fréquence est égale à la fréquence du signal d'horloge CK0 divisée par le nombre de bits que comprennent les mots binaires présents dans le plan mémoire. Le signal d'horloge CK1 cadence les opérations portant sur des mots binaires, notamment de lecture ou d'écriture du plan mémoire, d'incrémentation ou de décrémentation du compteur d'adresse EACNT, de chargement d'un mot binaire dans le registre OUTSREG ou de lecture d'un mot binaire dans le registre INSREG, etc.. Le signal d'horloge CK0 cadence les opérations liées à la transmission ou à la réception de bits sous forme série, notamment le décalage de bits dans les registres à décalage OUTSREG, INSREG et le cadencement des tampons OUTBUF, INBUF.

On décrira maintenant des aspects de l'invention relatifs à l'exécution de commandes comprenant une adresse étendue

### Exécution de commandes comprenant une adresse étendue

Les codes opération OPCODE et les adresses étendues EAD reçus sous forme série sur le contact IOP sont transformés par le registre INSREG en données parallèle appliquées sur le bus 5, et sont respectivement appliqués sur une entrée de l'unité centrale et une entrée du compteur d'adresse étendue EACNT. Lorsqu'une adresse EAD a été enregistrée dans le compteur d'adresse EACNT, celui-ci fournit les N premiers bits d'adresse A_{N-1}-A₀ (adresse ADL) au décodeur XYDEC, et fournit les bits d'adresse de poids fort A_{N+2}, A_{N+1}, A_{N} (adresse ADH) à des premières entrées du comparateur COMP.

Le registre d' indexation IDXREG comprend ici trois bits de référence R2, R1, R0 qui forment l'adresse de poids fort de référence RADH attribuée à la mémoire au sein du plan mémoire étendu. Ce plan mémoire étendu est ainsi adressable au maximum sous N+3 bits (K=3), et sa taille ne peut être supérieure ici à 8 fois la taille du plan mémoire intégré MA. Une adresse étendue comprend ainsi ici, au maximum, 3 bits d'adresse de poids fort A_{N+2}, A_{N+1}, A_{N}.

Les bits R2, R1, R0 sont appliqués sur des secondes entrées du comparateur COMP dont la sortie fournit le signal ADMATCH décrit plus haut.

Le signal ADMATCH est appliqué à l'unité centrale pour bloquer l'exécution de commandes d'écriture. Le signal ADMATCH est également appliqué sur une entrée d'une porte 10 de type NON OU à deux entrées, dont la sortie fournit un signal SHZ (Set High Z). Le signal SHZ est appliqué sur une entrée de commande du tampon de sortie OUTBUF par l'intermédiaire du circuit de synchronisation SYNCCT. Le tampon de sortie OUTBUF est un tampon trois états pouvant présenter un état de sortie à 0 (masse), à 1 (Vcc) ou à haute impédance (HZ). Lorsque le signal SHZ est à 1, le tampon OUTBUF met sa sortie à haute impédance. Le circuit de synchronisation SYNCCT est généralement transparent pour le signal SHZ, sauf dans un cas particulier décrit ci-après.

Ainsi, lorsque les bits de poids fort présents dans une adresse étendue reçue dans une commande ne correspondent pas avec les bits de référence, le signal ADMATCH passe à 0 et le signal SHZ passe à 1, ce qui fait basculer la sortie du tampon OUTBUF dans l'état haute impédance. Les données appliquées sur l'entrée série du tampon ne sont donc plus transmises sur le contact d'entrée/sortie IOP, ce qui permet de ne pas exécuter une commande de lecture. L'unité centrale, quant à elle, est configurée pour exécuter la commande de lecture, conformément à la méthode selon l'invention pour ne pas exécuter une commande de lecture, selon laquelle les données sont lues mais bloquées en sortie.

Le circuit SYNCCT devient non transparent vis-à-vis du signal SHZ quand un signal LOAD de chargement d'un mot binaire est appliqué au registre à décalage OUTSREG par l'unité centrale. A partir de cet instant, le circuit SYNCCT compte un nombre de cycles d'horloge CK0 correspondant au nombre de bits présents dans un mot binaire, soit un cycle d'horloge CK1, et redevient transparent lorsque le. cycle d'émission du mot binaire est terminé. Ainsi, si le signal SHZ passe à 1 alors qu'un mot binaire est en train d'être envoyé bit à bit sur le contact de sortie IOP, le blocage (mise à haute impédance) du tampon de sortie ne se produit qu'après que l'intégralité du mot a été envoyée.

On décrira maintenant les aspects de l'invention relatifs à la protection en lecture du plan mémoire étendu pendant une opération d'écriture.

### Protection du plan mémoire étendu pendant une écriture

Le circuit RBCT comprend un transistor interrupteur T1, ici de type NMOS, une porte 20 de type OU et une porte inverseuse 21. Les bornes de drain et de source du transistor T1 sont connectées respectivement au contact RBP et à la masse, tandis que la grille du transistor est pilotée par le signal IWIP fourni par l'unité centrale. La porte 21 est connectée en entrée au contact RBP. La porte 20 reçoit sur une entrée le signal IWIP, sur une autre entrée la sortie de la porte 21, et sa sortie fournit le signal EWIP.

Comme indiqué plus haut, le signal IWIP est mis à 1 lorsque l'unité centrale procède à une opération d'effacement et/ou de programmation dans le plan mémoire. Le contact RBP, qui est polarisé à la tension Vcc par la résistance RPU décrite précédemment, est alors forcé à 0 (masse) par le transistor T1. Par ailleurs, si le contact RBP est forcé à 0 par une autre mémoire (les contacts RBP étant interconnectés), le signal EWIP passe à 1 même si le signal IWIP est à 0. Ainsi, quand IWIP=0 et EWIP=1, l'unité centrale sait qu'une autre mémoire est en cours d'écriture et refuse d'exécuter une commande de lecture ou écriture, pour les raisons exposées plus haut.

On décrira maintenant des aspects de l'invention permettant d'obtenir une mémoire série qui est configurable et peut s'incorporer dans un plan mémoire étendu de taille variable.

### Réalisation d'une mémoire configurable

La mémoire comprend un registre de configuration CNFREG et un décodeur de configuration CNFDEC. Le registre CNFREG comprend une information sur la taille du plan mémoire étendu dans lequel la mémoire est incorporée. Cette information est ici le nombre K qui est codé en binaire au moyen de deux bits K1, K0, et peut varier entre K=0 et K=Kmax=3. La taille du plan mémoire étendu est ainsi égale à 2^{K} fois la taille du plan mémoire intégré MA, soit un nombre de points mémoire (mots binaires) égal à 2^{K}*2^{N} ou 2^{N+K}.

La sortie du registre CNFREG est appliquée au décodeur de configuration CNFDEC qui fournit, à partir de K, trois drapeaux F2, F1, F0 indiquant le nombre de bits d'adresse de poids fort que comprend l'adresse étendue du plan mémoire étendu.

A noter que les drapeaux F2, F1, F0 peuvent également être directement enregistrés dans le registre CNFREG, la mémorisation du paramètre K sous forme binaire étant prévue ici pour réduire la taille du registre CNFREG.

La relation entre le nombre K et les drapeaux F2, F1, F0 est décrite par le tableau 1 ci-après. La valeur décimale de K est décrite par la première colonne du tableau. La valeur binaire de K (bits K1, K0) est décrite par la deuxième colonne. La taille du plan mémoire étendu est décrite par la troisième colonne du tableau. Les quatrième, cinquième et sixième colonnes décrivent respectivement les valeurs des drapeaux F2, F1, F0 pour chaque valeur de K. La septième colonne mentionne les bits d'adresse de poids fort (bits d'adresse au-delà des N premiers bits) que comprend l'adresse étendue, pour chaque valeur de K. La dernière colonne décrit la valeur maximale MSBmax de l'adresse de poids fort dans le plan mémoire étendu, pour chaque valeur de K.

Il apparaît dans le tableau 1 qu'un drapeau F2, F1, F0 est à 1 lorsque le bit de poids fort correspondant est utilisé dans l'adresse étendue. Ainsi, K est une variable programmable qui peut varier de 0 à Kmax, avec ici Kmax=3, et le registre de configuration permet d'incorporer la mémoire dans un plan mémoire étendu comprenant 2 (K=1), 4 (K=2) ou 8 (K=3) mémoires ayant un plan mémoire intégré adressable sous N bits, ou de l'incorporer dans un plan mémoire étendu composite (composé de mémoires de tailles différentes) adressable sous N+K bits.

Il apparaît également dans le tableau 1 que le drapeau F0 est à 0 uniquement quand K est égal à 0. En d'autres termes, le fait que le drapeau F0 soit à 0 signifie que la mémoire n'est pas intégrée dans un plan mémoire étendu, et qu'il n'existe pas d'adresse de poids fort. La mémoire fonctionne alors en mode "classique", c'est-à-dire en exécutant toutes les commandes sans que son fonctionnement dépende de la comparaison des bits d'adresse de poids fort et des bits de référence R2, R1, R0.

**Tableau 1**

| K_{(décimal)} | K1 K0 | 2 ^{K}*2^{N} | F2 | F1 | F0 | MSB | MSBmax |
|---|---|---|---|---|---|---|---|
| 0 | 00 | 2^{N} | 0 | 0 | 0 | - | - |
| 1 | 01 | 2*2^{N} | 0 | 0 | 1 | A_{N} | 1 |
| 2 | 10 | 4*2^{N} | 0 | 1 | 1 | A_{N+1} + A_{N}, | 11 |
| 3 | 11 | 8*2^{N} | 1 | 1 | 1 | A_{N+2} A_{N+1} A_{N} | 111 |

Afin d'inhiber le mécanisme de comparaison des adresses de poids fort et des bits de référence quand F0=0, le drapeau F0 est appliqué à l'entrée d'une porte inverseuse 11 dont la sortie fournit un signal ADMATCH'. Le signal ADMATCH' est appliqué sur la deuxième entrée de la porte 10. Ainsi, lorsque F0=0, ADMATCH' est à 1 et le signal SHZ est forcé à 0, de sorte que le tampon OUTBUF ne peut pas être mis dans l'état haute impédance.

D'autre part, afin d'adapter le fonctionnement de la mémoire au nombre K de bits de poids fort que comprend l'adressage étendu, le compteur d'adresse étendue et/ou le comparateur présentent une configuration variable qui est fonction de K.

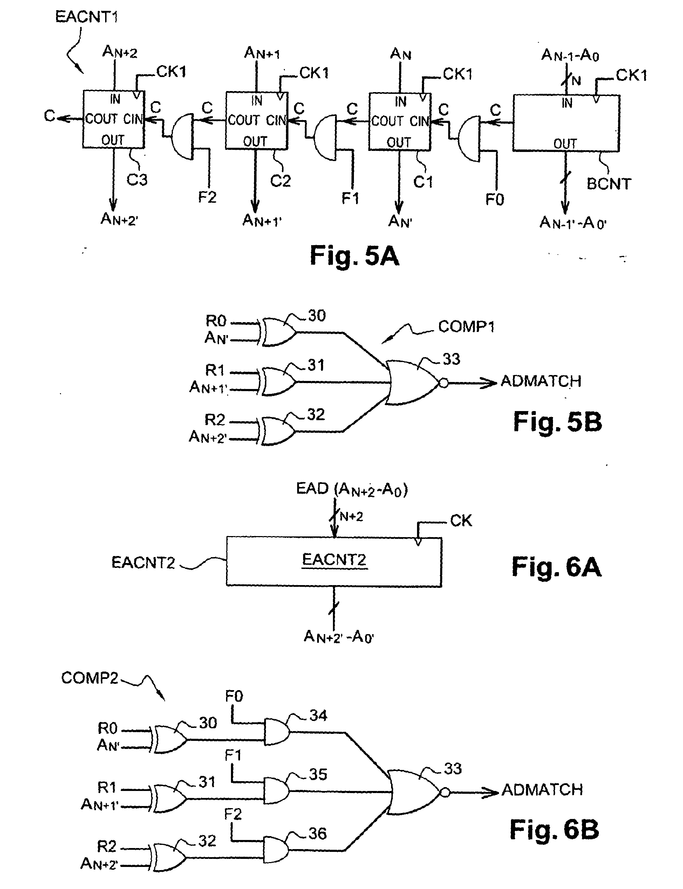

Les figures 5A et 5B représentent respectivement un premier mode de réalisation EACNT1 du compteur d'adresse étendue et un premier mode de réalisation COMP1 du comparateur. Selon ce premier mode de réalisation de ces éléments, le compteur d'adresse comprend un nombre variable de cellules de comptage actives, qui est fonction de K, tandis que le comparateur comprend un nombre d'entrées de comparaison qui est fixe et égal à Kmax.

Plus particulièrement, le compteur d'adresse EACNT1 comprend un bloc de comptage de base BCNT comprenant N cellules de comptage de 1 bit chacune (non représentées) et trois cellules de comptage supplémentaires C1, C2, C3 de 1 bit chacune, agencées à l'extérieur du bloc de comptage de base. Les diverses cellules de comptage sont cadencées par le signal d'horloge CK1.

Le bloc de comptage de base BCNT reçoit en entrée les bits d'adresse A_{N-1}-A₀, soit l'adresse ADL, et fournit des bits d'adresse A_{N-1}-A₀'. Les bits d'adresse A_{N-1}'-A₀' sont égaux aux bits d'adresse reçus en entrée dans le cas d'une commande de lecture ou d'écriture à adresse fixe, ou forment une adresse incrémentée ou décrémentée au rythme du signal d'horloge CK1 dans le cas d'une commande de lecture continue. Le bloc de comptage BCNT fournit un bit de report de somme C (Carry) lorsqu'il atteint la valeur de débordement (tous les bits d'adresse à 1) et au moment où il repasse à 0.

Les cellules de comptage C1, C2, C3 comprennent chacune une entrée In pour recevoir un bit d'adresse de poids fort, respectivement A_{N}, A_{N+1}, A_{N+2}, formant ensemble l'adresse ADH, et une sortie fournissant des bits d'adresse A_{N}', A_{N+1}', A_{N+2}', respectivement. Chaque cellule de comptage C1, C2, C3 comprend une entrée CIN pour recevoir le bit C de rang précédent et une sortie COUT pour fournir le bit C de rang suivant. L'entrée CIN de la cellule C1 reçoit le bit C fournit par le bloc BCNT par l'intermédiaire d'une porte ET dont l'autre entrée reçoit le drapeau F0. L'entrée CIN de la cellule C2 reçoit le bit C fournit par la cellule C1 par l'intermédiaire d'une porte ET dont l'autre entrée reçoit le drapeau F1. L'entrée CIN de la cellule C3 reçoit le bit C fournit par la cellule C2 par l'intermédiaire d'une porte ET dont l'autre entrée reçoit le drapeau F2. Lorsque les drapeaux F0, F1, F2 sont à 1 (K=Kmax=3) les trois cellules sont actives et connectées en cascade au bloc BCNT. Les bits d'adresse A_{N}', A_{N+1}', A_{N+2}' sont alors égaux aux bits d'adresse reçus en entrée dans le cas d'une commande de lecture ou écriture à adresse fixe, ou forment une adresse de poids fort incrémentée ou décrémentée au rythme du signal d'horloge CK1 dans le cas d'une commande de lecture continue. Lorsque le drapeau F2 est à 0 et que les drapeaux F1, F0 à 1 (K=2), la cellule C3 est déconnectée du reste du compteur par la porte ET correspondante. Sa sortie reste à 0 pendant un cycle de lecture continue et n'intervient pas dans la détermination du signal ADMATCH fournit par le comparateur. Lorsque les drapeaux F2, F1 sont à 0 et le drapeau F0 à 1 (K=1) , les cellules C3, C2 sont déconnectées du reste du compteur d'adresse et leurs sorties restent à 0 pendant un cycle de lecture continue et n'interviennent pas dans la détermination du signal ADMATCH fournit par le comparateur. Enfin, lorsque les drapeaux F0 à F2 sont tous à 0, les trois cellules sont déconnectées et le compteur d'adresse ne comprend que le compteur de base BCNT, qui est équivalent à un compteur d'adresse d'une mémoire classique. La mémoire fonctionne dans ce cas en mode "classique": le signal ADMATCH' est à 1 et force à 0 le signal SHZ, comme décrit plus haut.

Le comparateur COMP1 représenté sur la figure 5B comprend des portes 30, 31, 32 de type OU EXCLUSIF et une porte 33 de type NON OU. La porte 30 reçoit en entrée le bit de référence R0 et le bit d'adresse de poids fort A_{N}'. La porte 31 reçoit en entrée le bit de référence R1 et le bit d'adresse de poids fort A_{N+1}'. La porte 32 reçoit en entrée le bit de référence R2 et le bit d'adresse de poids fort A_{N+2}'. La porte 33 présente trois entrées reliées respectivement aux sorties des portes 30, 31, 32, et fournit le signal ADMATCH.

Les figures 6A et 6B représentent respectivement un second mode de réalisation EACNT2 du compteur d'adresse étendue et un second mode de réalisation COMP2 du comparateur. Selon ce second mode de réalisation, le compteur d'adresse EACNT2 comprend un nombre invariable N+Kmax de cellules de comptage actives. Le compteur EACNT2 est l'équivalent du compteur EACNT1 dans lequel les portes ET permettant de filtrer les bits de report de somme C sont supprimées et remplacées par des connexions directes.

Le comparateur COMP2 présente les mêmes portes que le comparateur COMP1 décrit ci-dessus, désignées par les mêmes références. Il comprend en outre des portes 34, 35, 36 de type ET. La porte 34 reçoit en entrée la sortie de la porte 30 et le drapeau F0. Sa sortie est appliquée sur la première entrée de la porte 33. La porte 35 reçoit en entrée la sortie de la porte 31 et le drapeau F1. Sa sortie est appliquée sur la deuxième entrée de la porte 33. La porte 36 reçoit en entrée la sortie de la porte 32 et le drapeau F2. Sa sortie est appliquée sur la troisième entrée de la porte 33. Ainsi, les entrées du comparateur sont inhibées par les drapeaux F0, F1, F2 lorsque ceux-ci sont à 0. Plus particulièrement, les entrées du comparateur correspondant aux entrées de la porte 30 sont inhibées lorsque le drapeau F0 est à 0. Les entrées du comparateur correspondant aux entrées des portes 30, 31 sont inhibées lorsque les drapeaux F0, F1 sont à 0. Enfin, toutes les entrées du comparateur sont inhibées lorsque tous les drapeaux F0, F1, F2 sont à 0, le signal ADMATCH étant alors forcé à 1. Ce mode de réalisation du comparateur permet de supprimer les portes 10, 11, le signal ADMATCH pouvant être directement appliqué au circuit SYNCCT.

En définitive, la mémoire série selon l'invention présente une configuration programmable lui permettant de fonctionner comme une mémoire série classique, ou d'être intégrée dans un plan mémoire étendu dont la taille est de 2 fois, 4 fois ou 8 fois la taille de son propre plan mémoire.

La programmation du registre de configuration CNFREG est de préférence faite par software, au moyen d'une commande spécifique que l'unité centrale exécute. Cette programmation peut être prévue lorsque toutes les mémoires sont interconnectées, car la valeur de K est la même pour toutes les mémoires. La programmation du registre d'indexation IDXREG doit, par contre, être assurée avant l'interconnexion des mémoires, car chaque mémoire doit recevoir une adresse de poids fort individuelle et l'exécution d'une commande individuelle d'écriture du registre IDXREG ne peut être envisagée tant qu'une d'adresse de poids fort n'y est pas inscrite. Le registre IDXREG peut par exemple être programmé lors de la fabrication des microplaquettes de silicium, lesquelles sont ensuite classées par lots, chaque lot correspondant à une adresse de poids fort. Cette solution va toutefois à l'encontre de la flexibilité recherchée. Selon l'invention, une solution plus avantageuse consiste à prévoir des contacts électriques, ici trois contacts IDXP0, IDXP1, IDXP2 reliés à des entrées du registre IDXREG correspondant respectivement aux bits de référence R0, R1, R2. Les contacts IDXP0, IDXP1, IDXP2 sont reliés à la masse par une résistance tire-bas RPD de forte valeur, individuelle ou collective. Lorsque la microplaquette de silicium est agencée dans un boîtier, chaque contact IDXP0, IDXP1, IDXP2 est connecté à la tension Vcc pour programmer à 1 du bit de référence correspondant, ou est laissé déconnecté pour programmer à 0 le bit de référence correspondant. Si aucun des trois contacts IDXP0, IDXP1, IDXP2 n'est connecté à la tension Vcc, tous les bits de référence sont à 0 et la-mémoire fonctionne en mode "classique". Divers perfectionnements de ce principe de programmation statique par câblage peuvent être prévus par l'homme de l'art. Notamment, peut être prévu un circuit de contrôle permettant de déconnecter la résistance RPD des contacts IDXP0, IDXP1, IDXP2 lorsque le registre IDXREG est programmé, afin d'éviter qu'un courant de fuite ne circule en permanence dans la résistance RPD.

Le tableau 2 ci-après décrit les diverses adresses de poids fort pouvant être chargées dans le registre IDXREG en fonction de la valeur de K (K1 K0) chargée dans le registre CNFREG.

**Tableau 2**

| CNFREG (K1 K0) | IDXREG (R2 R1 R0) |
|---|---|
| 00 | 000 |
| 01 | 000 ou 001 |
| 10 | de 000 à 011 |
| 11 | de 000 à 111 |

On décrira maintenant un aspect de l'invention se rapportant à la lecture de l'un des registres spéciaux. Le but de l'invention est ici de faire en sorte que, lorsqu'une commande de lecture d'un tel registre est appliquée à un ensemble de mémoires, une seule mémoire traite la commande et fournit sur le bus série le contenu du registre spécial, afin d'éviter des collisions de réponses.

### Lecture de registres spéciaux

La mémoire comprend un décodeur de mémoire maître MSTDEC qui fournit un signal MASTER (Fig. 6). Lorsque le signal MASTER est à 1, la mémoire est considérée comme mémoire maître au sein du plan mémoire étendu tandis que les autres mémoires sont considérées comme esclaves. Une seule mémoire pouvant être maître au sein du même plan mémoire étendu, le signal MASTER doit être à 1 pour une seule mémoire. Selon l'invention, une solution parmi d'autres est de conférer le statut de mémoire maître à celle qui reçoit dans le registre IDXREG une adresse de poids fort qui est la plus forte adresse de poids fort du plan mémoire étendu. A cet effet, le décodeur MSTDEC reçoit en entrée les bits de référence R0, R1, R2 et les bits K1, K0 formant le nombre K. Le tableau 3 ci-après décrit la fonction logique de production du signal MASTER exécutée par le décodeur MSTDEC. Il apparaît que pour chaque valeur de K, le signal MASTER est à 1 lorsque l'adresse de poids fort R2 R1 R0 correspond à la plus forte valeur possible dans le plan mémoire étendu. Quand K=0, le signal MASTER est toujours à 1 puisque la mémoire fonctionne dans le mode "classique".

Selon l'invention, l'unité centrale UC est configurée pour n'exécuter une commande de lecture de l'un des registres spéciaux STREG, IDREG qu'à la condition que le signal MASTER soit à 1. Le registre est alors transféré sur la sortie IOP de la mémoire via le bus de données interne 5 et le circuit IOCT. Ainsi, vu de l'extérieur, le plan mémoire étendu présente un caractère unitaire en ce qui concerne la lecture des registres spéciaux puisque c'est toujours la mémoire maître qui répond aux commandes de lecture. En d'autres termes, tout se passe comme si le plan mémoire étendu ne comportait qu'un seul exemplaire de chacun des registres spéciaux, ceux des mémoires esclaves n'étant jamais lus et demeurant non accessibles depuis l'extérieur.

**Tableau 3**

| K_{(décimal)} | CNFREG (K1 K0) | IDXREG (R2 R1 R0) | MASTER |
|---|---|---|---|
| 0 | 00 | 000 | 1 |
| 1 | 01 | 001 | 1 |
| 1 | 01 | 000 | 0 |
| 2 | 10 | 011 | 1 |
| 2 | 10 | de 000 à 010 | 0 |
| 3 | 11 | 111 | 1 |
| 3 | 11 | de 000à 110 | 0 |

Les registres spéciaux des mémoires esclaves, bien qu'ils ne soient pas accessibles en lecture, doivent toutefois pouvoir être programmés car ils peuvent agir sur le fonctionnement de ces mémoires. Ainsi, selon l'invention, les bits de protection en écriture P0 à Pi sont affectés à la protection en écriture de fractions du plan mémoire étendu plutôt qu'à la protection de fractions du plan mémoire intégré de la mémoire dans laquelle ils sont enregistrés. Ces bits concernent donc chacune des mémoires, notamment celles qui font partie, le cas échéant, de la fraction du plan mémoire étendu à protéger en écriture. Egalement, le bit WEN est utilisé comme un bit collectif affecté à la protection générale en écriture du plan mémoire étendu, et non à la protection en écriture d'une mémoire déterminée.

Ainsi, et à l'inverse des commandes de lecture, des commandes d'écriture des registres spéciaux sont exécutées par toutes les mémoires, maîtres ou esclaves. Les registres spéciaux contiennent ainsi strictement la même valeur dans chacune des mémoires du plan mémoire étendu et forment chacun l'équivalent d'un registre collectif unique.

Une variante de cet aspect de l'invention consiste à conférer le statut de mémoire maître à la mémoire ayant la plus faible adresse de poids fort, soit tous les bits de référence à 0. Dans ce cas, il n'est pas nécessaire que la mémoire compare ses bits de référence aux bits K0, K1 du nombre K pour savoir si elle est mémoire maître ou non.

### Lecture continue du plan mémoire étendu

L'exécution d'une commande de lecture continue sera maintenant décrite plus en détail. Une telle commande comporte une adresse étendue EAD0 de commencement de lecture, soit une adresse de N+K bits :

### [CODE(lecture_continue), EAD₀]

Lorsqu'une telle commande de lecture continue est reçue, les unités centrales respectives des mémoires incrémentent ou décrémentent continuellement et simultanément leurs compteurs d'adresse étendue, et chacune fournit les données demandées lorsque les bits de poids fort du compteur d'adresse étendue deviennent égaux aux bits de référence présents dans le registre d'indexation. Comme les compteurs d'adresse étendue respectifs des diverses mémoires -comportent à chaque instant la même valeur d'adresse étendue, les mémoires se relayent automatiquement pour fournir sur le bus série le contenu de leurs plans mémoire intégrés respectifs, ce qui correspond, vu de l'extérieur, à une mémoire unique comportant un plan mémoire intégré de grande taille qui effectuerait une opération de lecture continue de son plan mémoire.

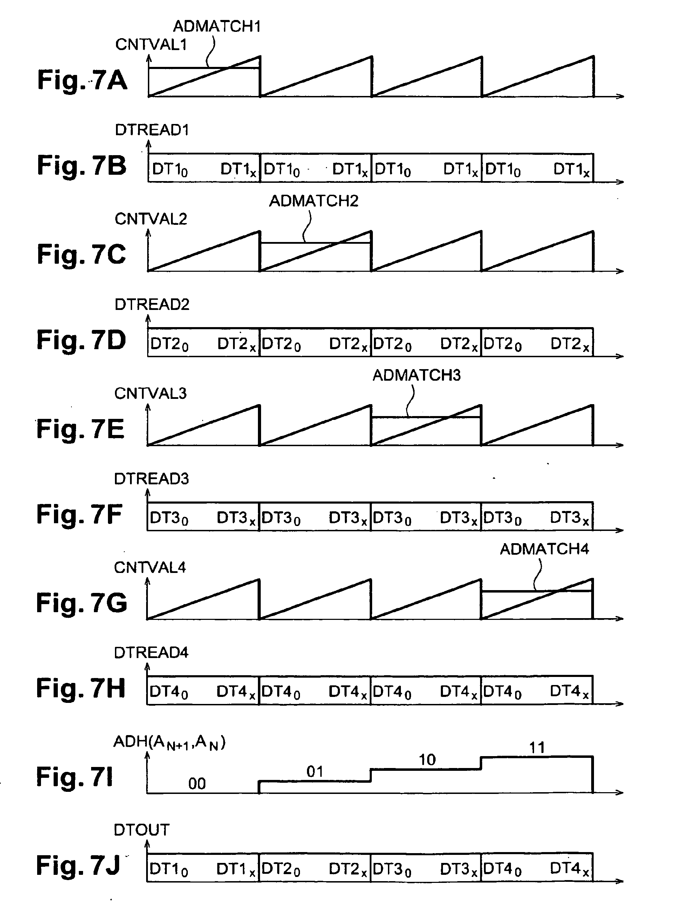

Pour fixer les idées, les figures 7A à 7J illustrent l'exécution d'une commande de lecture continue du plan mémoire étendu représenté en figure 3, formé par les mémoires MEM1 à MEM4. Les figures 7A, 7C, 7E, 7G, représentent des valeurs de comptage CNTVAL1, CNTVAL2, CNTVAL3, CNTVAL4 formées par les N premiers bits du compteur d'adresse étendue des mémoires MBM1, MEM2, MEM3, MEM4, respectivement, soit les adresse ADL. Les figures 7A, 7C, 7E, 7G, représentent également les valeurs des signaux ADMATCH1, ADMATCH2, ADMATCH3, ADMATCH4 à la sortie des comparateurs respectifs des mémoires MEM1, MEM2, MEM3, MEM4. Les figures 7B, 7D, 7F, 7H représentent les données DTREAD1, DTREAD2, DTREAD3, DTREAD4 lues dans les plans mémoire intégrés des mémoire MEM1, MEM2, MEM3, MEM4, respectivement. La figure 7I représente la valeur de comptage de poids fort formée par les deux bits de poids fort A_{N+1}, A_{N} (car ici K=2) présents dans le compteur d'adresse étendue de chaque mémoire, soit l'adresse ADH. La figure 7J représente les données DTOUT qui sont fournies par le plan mémoire intégré. On suppose ici que la lecture continue commence à l'adresse zéro du plan mémoire étendu, et que la mémoire MEM1 est celle qui présente l'adresse de poids fort la plus faible, soit A_{N+1} A_{N} = 00.

Au cours de la lecture continue, les valeurs de comptage de poids faible CNTVAL1, CNTVAL2, CNTVAL3, CNTVAL4 effectuent plusieurs cycles de comptage en repassant chaque fois par zéro (fig. 7A, 7C, 7E, 7G) tandis que la valeur de comptage de poids fort augmente d'une unité à chaque cycle. A chaque cycle, les unités centrales des mémoires lisent l'ensemble de leurs plans mémoire respectifs, mais ces données ne sont fournies en sortie que lorsque le signal ADMATCH est à 1. Ainsi, les données fournies au cours du premier cycle de comptage sont celles qui sont lues par la mémoire MEM1, et s'étendent du premier mot binaire DT10 jusqu'au dernier mot binaire DT1x présent dans la mémoire MEM1. Les données fournies au cours du second cycle de comptage sont celles qui sont lues par la mémoire MEM2 et s'étendent du premier mot binaire DT20 jusqu'au dernier mot binaire DT2x présent dans la mémoire MEM2. De même, les données fournies au cours du troisième cycle de comptage sont celles qui sont lues par la mémoire MEM3 et s'étendent du premier mot binaire DT30 jusqu'au dernier mot binaire DT3x présent dans la mémoire MEM3. Au cours du quatrième et dernier cycle de comptage, les données fournies sont celles qui sont lues par la mémoire MEM4, et s'étendent du premier mot binaire DT40 jusqu'au dernier mot binaire DT4x présent dans la mémoire MEM4. L'arrêt du processus de lecture peut toutefois intervenir à tout instant, et est généralement déclenché en cessant d'appliquer le signal d'horloge CK0 aux mémoires.

Ainsi, la non-exécution d'une commande de lecture continue en effectuant une lecture du plan mémoire intégré tout en bloquant les données à la sortie de la mémoire, présente un avantage déterminant relativement à une méthode qui consisterait à ne pas effectuer la lecture du plan mémoire. Cette autre méthode nécessiterait la prévision d'un décodeur complexe portant sur tous les bits d'adresse du compteur pour anticiper l'instant où des données vont devoir être fournies, afin d'initialiser la lecture du plan mémoire en temps utile pendant l'exécution d'une commande de lecture continue au cours de laquelle le compteur d'adresse étendue est sans cesse incrémenté ou décrémenté.

Il apparaîtra clairement à l'homme de l'art qu'une mémoire selon l'invention est susceptible de diverses variantes et modes de réalisation. Diverses combinaisons des moyens de l'invention peuvent être prévues, certains moyens pouvant ne pas être mis en oeuvre. Notamment, la mise en oeuvre du contact de disponibilité/occupation RBP et du signal EWIP ne se justifie que si le plan mémoire intégré de chaque mémoire est accessible à la fois en lecture et en écriture (par exemple un plan mémoire de type Flash ou EEPROM). Egalement, la prévision du compteur d'adresse configurable et/ou du comparateur configurable ne se justifie que si l'on souhaite prévoir une mémoire configurable, destinée à être incorporée dans un plan mémoire étendu dont la taille n'est pas prédéterminée. De même, la prévision du signal de mémoire maître ne se justifie que si l'on souhaite prévoir un plan mémoire étendu capable de répondre à une commande de lecture de registres spéciaux. Enfin, bien que l'on ait décrit dans un souci de simplicité la réalisation d'un plan mémoire étendu comportant des mémoires ayant des plans mémoire intégrés de même taille, l'invention s'applique également à la réalisation d'un plan mémoire étendu composite. Dans ce cas, N et K sont différents dans chaque mémoire mais la somme de N et de K est constante et égale au nombre de bits que comprend l'adresse étendue du plan mémoire étendu composite.

## Revendications

1. Mémoire (MEM) sur microplaquette de silicium, comprenant :
- une entrée/sortie série et un plan mémoire intégré (MA),
- des moyens (IDXREG) pour mémoriser une adresse de poids fort (RADH) attribuée à la mémoire au sein d'un plan mémoire étendu adressable avec une adresse étendue (EAD) comprenant une adresse de poids faible (ADL) et une adresse de poids fort (ADH),
- un compteur d'adresse étendue (EACNT) pour mémoriser une adresse étendue (EAD) reçue sur l'entrée/sortie série de la mémoire, et appliquer l'adresse de poids faible (ADL) au plan mémoire intégré (MA) ,
- des moyens (COMP) pour comparer l'adresse de poids fort (ADH) de l'adresse étendue avec l'adresse de poids fort (RADH) attribuée à la mémoire, et
- des moyens (COMP, ADMATCH, SHZ, OUTBUF, UC) pour empêcher l'exécution d'une commande de lecture ou d'écriture du plan mémoire intégré si l'adresse de poids fort (ADH) de l'adresse étendue est différente de l'adresse de poids fort (RADH) attribuée à la mémoire,
**caractérisée en ce que** les moyens pour empêcher l'exécution d'une commande de lecture du plan mémoire sont agencés pour laisser la mémoire effectuer la lecture de son plan mémoire intégré tout en empêchant les données lues dans le plan mémoire intégré d'être appliquées sur l'entrée/sortie série de la mémoire .

2. Mémoire selon la revendication 1, comprenant
- un circuit tampon de sortie (OUTBUF) pour fournir sur l'entrée/sortie série de la mémoire des données lues dans le plan mémoire intégré (MA), et
- des moyens (COMP) pour fournir un signal de blocage (ADMATCH, SHZ) du circuit tampon de sortie si l'adresse de poids fort (ADH) de l'adresse étendue est différente de l'adresse de poids fort (RADH) attribuée à la mémoire.

3. Mémoire selon la revendication 2, comprenant un circuit de décalage temporel (SYNCCT) pour décaler dans le temps l'application du signal de blocage (ADMATCH, SHZ) au circuit tampon de sortie (OUTBUF) si, au moment où le signal de blocage passe à une valeur active, le circuit tampon de sortie est en train de fournir sur l'entrée/sortie série les bits d'une donnée lue dans le plan mémoire intégré (MA) avant que le signal de blocage ne passe à la valeur active.

4. Mémoire selon l'une des revendications 1 à 3, comprenant une unité centrale (UC) pour exécuter une commande de lecture continue du plan mémoire étendu en incrémentant ou décrémentant continuellement le compteur d'adresse étendue (EACNT) y compris lorsque l'adresse de poids fort (ADH) de l'adresse étendue est différente de l'adresse de poids fort (RADH) attribuée à la mémoire, jusqu'à l'arrêt de l'exécution de la commande de lecture continue.

5. Mémoire selon la revendication 4, dans laquelle l'unité centrale est agencée pour lire continuellement le plan mémoire intégré (MA) pendant l'exécution d'une commande de lecture continue, y compris lorsque l'adresse de poids fort (ADH) de l'adresse étendue est différente de l'adresse de poids fort (RADH) attribuée à la mémoire.

6. Mémoire selon l'une des revendications 1 à 5, comprenant :
- des moyens (CNFREG) pour mémoriser une information (K1, K0) sur un nombre K de bits que comprend l'adresse de poids fort de l'adresse étendue, K étant une variable comprise entre 0 et Kmax, Kmax étant non nul,
- un compteur d'adresse étendue (EACNT) comprenant N+Kmax cellules de comptage, N étant le nombre de bits de l'adresse de poids faible (ADL), et
- des moyens pour mémoriser Kmax bits de référence parmi lesquels K bits de référence (R2-R0) représentent l'adresse de poids fort (RADH) attribuée à la mémoire.

7. Mémoire selon la revendication 6, comprenant un registre de configuration (CNFRDG) pour mémoriser Kmax drapeaux (F2-F0) correspondant par leur nombre et leur rang aux bits que peut contenir au maximum l'adresse de poids fort de l'adresse étendue, chaque drapeau présentant une valeur logique déterminée si un bit de rang correspondant est présent dans l'adresse de poids fort de l'adresse étendue, de sorte que le nombre de drapeaux (F2-F0) ayant la valeur logique déterminée définit le nombre de bits présents dans l'adresse de poids fort de l'adresse étendue.

8. Mémoire selon la revendication 6, comprenant un registre de configuration (CNFRDG) pour mémoriser un nombre binaire codé donnant une indication sur la taille du plan mémoire étendu, et un circuit de décodage fournissant, à partir du nombre binaire codé, Kmax drapeaux (F2-F0) correspondant par leur nombre et leur rang aux bits que peut contenir au maximum l'adresse de poids fort de l'adresse étendue, chaque drapeau présentant une valeur logique déterminée si le bit de rang correspondant est présent dans l'adresse de poids fort de l'adresse étendue, de sorte que le nombre de drapeaux (F2-F0) ayant la valeur logique déterminée définit le nombre de bits présents dans l'adresse de poids fort de l'adresse étendue.

9. Mémoire selon l'une des revendications 6 à 8, comprenant des moyens pour désactiver des cellules de comptage du compteur d'adresse étendue (EACNT) en fonction de l'information (K1, K0) sur le nombre de bits que comprend l'adresse de poids fort de l'adresse étendue, de manière que le compteur ne comprenne que N+K cellules de comptage actives.

10. Mémoire selon l'une des revendications 6 à 9, dans laquelle les moyens pour comparer l'adresse de poids fort de l'adresse étendue avec l'adresse de poids fort (RADH) attribuée à la mémoire comprennent un comparateur (COMP) et des moyens pour inhiber des entrées du comparateur (COMP) en fonction de l'information (K1, K0) sur le nombre de bits que comprend l'adresse de poids fort d'une adresse étendue, de manière que le comparateur (COMP) ne comprenne que K entrées actives.

11. Mémoire selon l'une des revendications 1 à 10, comprenant :
- un contact (RBP) de disponibilité/occupation pouvant être forcé depuis l'extérieur à un potentiel électrique déterminé, et
- des moyens internes (RBCT) pour forcer au potentiel électrique déterminé le contact (RBP) de disponibilité/occupation, pendant une opération d'effacement ou de programmation du plan mémoire intégré (MA),
la mémoire étant agencée pour ne pas exécuter une commande de lecture ou d'écriture lorsque le potentiel électrique du contact (RBP) de disponibilité/occupation présente le potentiel déterminé (GND).

12. Mémoire selon l'une des revendications 1 à 11, comprenant des contacts spécifiques (IDXPO-IDXP2) permettant de configurer des bits de référence (R2-R0) représentant l'adresse de poids fort (RADH) attribuée à la mémoire, en appliquant des potentiels électriques déterminés sur les contacts spécifiques.

13. Plan mémoire étendu comprenant une combinaison d'au moins deux mémoires selon l'une des revendications 1 à 12, dans lequel les entrées/sorties série de chaque mémoire sont interconnectées.

14. Plan mémoire étendu comprenant une combinaison d'au moins deux mémoires selon la revendication 11, dans lequel les entrées/sorties série de chaque mémoire sont interconnectées et les contacts de disponibilité/occupation de chaque mémoire sont interconnectés.

15. Procédé pour la réalisation d'un plan mémoire étendu adressable avec une adresse étendue (EAD) comprenant une adresse de poids faible (ADL) et une adresse de poids fort (ADH), le plan mémoire étendu comprenant une pluralité de mémoires série (MEM1-MEM4) intégrées sur microplaquettes de silicium, chaque mémoire comprenant une entrée/sortie série et un plan mémoire intégré (MA) adressable avec l'adresse de poids faible (ADL), les entrées/sorties série des mémoires étant interconnectées, procédé comprenant les étapes consistant à :
- prévoir, dans chaque mémoire, des moyens (IDXREG) pour mémoriser une adresse de poids fort (RADH) attribuée à la mémoire au sein du plan mémoire étendu,
- prévoir, dans chaque mémoire, un compteur d'adresse étendue (EACNT) pour mémoriser une adresse étendue (EAD),
- attribuer une adresse de poids fort (RADH) à chaque mémoire,
- appliquer aux mémoires une commande de lecture ou d'écriture comprenant une adresse étendue, et
- empêcher l'exécution d'une commande de lecture ou d'écriture dans chaque mémoire ayant une adresse de poids fort attribuée (RADH) qui est différente de l'adresse de poids fort (ADH) présente dans la commande de lecture ou d'écriture
procédé **caractérisé en ce que** l'étape consistant à empêcher l'exécution d'une commande de lecture dans une mémoire comprend le fait de laisser la mémoire lire son plan mémoire intégré tout en empêchant les données lues dans le plan mémoire intégré d'être appliquées sur l'entrée/sortie série de la mémoire.

16. Procédé selon la revendication 15, comprenant les étapes consistant à :
- prévoir, dans chaque mémoire, un contact (RBP) de disponibilité/occupation,
- prévoir, dans chaque mémoire, des moyens (RBCT, UC) pour forcer à un potentiel électrique déterminé le contact (RBP) de disponibilité/occupation, pendant une opération d'effacement ou de programmation du plan mémoire intégré (MA),
- interconnecter les contacts de disponibilité/occupation des mémoires, et
- configurer chaque mémoire pour qu'elle n'exécute pas une commande de lecture ou d'écriture lorsque le potentiel électrique du contact (RBP) de disponibilité/occupation présente le potentiel déterminé (GND).

17. Procédé selon la revendication 15, dans lequel chaque mémoire comprend un circuit tampon de sortie (OUTBUF) pour fournir sur l'entrée/sortie série de la mémoire des données lues dans le plan mémoire intégré (MA), et dans lequel l'étape consistant à empêcher des données lues dans le plan mémoire intégré d'être fournies sur l'entrée/sortie de la mémoire comprend l'application d'un signal de blocage (ADMATCH, SHZ) au circuit tampon de sortie (OUTBUF) de la mémoire.

18. Procédé selon l'une des revendications 15 à 17, pour la réalisation d'un plan mémoire étendu pouvant répondre à une commande de lecture continue du plan mémoire, comprenant les étapes consistant à :
- appliquer aux mémoires une commande de lecture étendue comportant une adresse étendue (EAD) de commencement de lecture, et
- incrémenter ou décrémenter continuellement le compteur d'adresse étendue (EACNT) de chaque mémoire, y compris lorsque les bits d'adresse de poids fort de l'adresse étendue sont différents de l'adresse de poids fort (RADH) attribuée à la mémoire, jusqu'à l'arrêt de l'exécution de la commande de lecture continue.

19. Procédé selon la revendication 18, dans lequel le plan mémoire intégré (MA) de chaque mémoire est lu continuellement pendant l'exécution d'une commande de lecture continue, y compris lorsque l'adresse de poids fort (ADH) de l'adresse étendue est différente de l'adresse de poids fort (RADH) attribuée à la mémoire.

20. Procédé selon l'une des revendications 15 à 19, comprenant la prévision, dans chaque mémoire, de moyens (CNFREG) pour mémoriser une information (K1, K0) sur le nombre K de bits de poids fort que peut comprendre au maximum l'adresse de poids fort de l'adresse étendue, K étant une variable comprise entre 0 et Kmax, Kmax étant non nul.

21. Procédé selon la revendication 20, pour la réalisation d'un plan mémoire étendu de taille variable adressable au moyen d'une adresse étendue pouvant aller de N bits à N+Kmax bits, sans modifier l'architecture des mémoires composant le plan mémoire étendu, N étant le nombre de bits de l'adresse de poids faible (ADL), et comprenant des étapes consistant à :
- prévoir, dans chaque mémoire, un compteur d'adresse étendue (EACNT) comprenant N+Kmax cellules de comptage
- prévoir, dans chaque mémoire, des moyens pour mémoriser Kmax bits de référence, et
- attribuer à chaque mémoire au moins K bits de référence (R2-R0) formant une adresse de poids fort (RADH) .

22. Procédé selon la revendication 21, comprenant la désactivation de cellules de comptage du compteur d'adresse étendue (EACNT) en fonction de l'information (K1, K0) sur le nombre K, de manière que le compteur ne comprenne que N+K cellules de comptage actives.

23. Procédé selon l'une des revendications 21 et 22, dans lequel seulement K bits de référence (R2-R0) sont comparés avec K bits d'adresse de poids fort (ADH) présents dans le compteur, sans tenir compte des Kmax-K autres bits d'adresse présents dans le compteur.

24. Procédé selon l'une des revendications 20 à 23, dans lequel l'information (K1, K0) sur le nombre K est fournie aux mémoires sous la forme d'un nombre binaire codé donnant une indication sur la taille du plan mémoire étendu.

25. Procédé selon l'une des revendications 15 à 24, comprenant la prévision de contacts spécifiques (IDXPO-IDXP2) dans chaque mémoire et la configuration de l'adresse de poids fort (RADH) attribuée à chaque mémoire en appliquant des potentiels électriques déterminés sur les contacts spécifiques.

## Claims

1. A memory (MEM) on a silicon microchip, comprising :
- a serial input/output and an integrated memory array (MA),
- means (IDXREG) for storing a most significant address (RADH) allocated to the memory within an extended memory array addressable with an extended address (EAD) comprising a least significant address (ADL) and a most significant address (ADH),
- an extended address counter (EACNT) for storing an extended address (EAD) received at the serial input/output of the memory, and applying the least significant address (ADL) to the integrated memory array (MA),
- means (COMP) for comparing the most significant address (ADH) of the extended address with the most significant address (RADH) allocated to the memory, and
- means (COMP, ADMATCH, SHZ, OUTBUF, UC) for preventing the execution of a command for reading or writing the integrated memory array if the most significant address (ADH) of the extended address is different to the most significant address (RADH) allocated to the memory,
**characterized in that** the means for preventing the execution of a command for reading the memory array are arranged to allow the memory to perform the reading of its integrated memory array while preventing the data read in the integrated memory array from being applied to the serial input/output of the memory.

2. Memory according to claim 1, comprising
- an output buffer circuit (OUTBUF) for supplying data read in the integrated memory array (MA) to the serial input/output of the memory, and
- means (COMP) for supplying a signal for blocking (ADMATCH, SHZ) the output buffer circuit if the most significant address (ADH) of the extended address is different to the most significant address (RADH) allocated to the memory.

3. Memory according to claim 2, comprising a time lag circuit (SYNCCT) to shift in time the application of the blocking signal (ADMATCH, SHZ) to the output buffer circuit (OUTBUF) if, at the moment at which the blocking signal changes to an active value, the output buffer circuit is supplying to the serial input/output the bits of a datum read in the integrated memory array (MA) before the blocking signal changes to the active value.

4. Memory according to one of claims 1 to 3, comprising a central processing unit (UC) for executing a command for continuously reading the extended memory array by continuously incrementing or decrementing the extended address counter (EACNT) including when the most significant address (ADH) of the extended address is different to the most significant address (RADH) allocated to the memory, until the execution of the continuous read command stops.

5. Memory according to claim 4, wherein the central processing unit is arranged for continuously reading the integrated memory array (MA) during the execution of a continuous read command, including when the most significant address (ADH) of the extended address is different to the most significant address (RADH) allocated to the memory.

6. Memory according to one of claims 1 to 5, comprising:
- means (CNFREG) for storing a piece of information (K1, K0) about a number K of bits that the most significant address of the extended address comprises, K being a variable between 0 and Kmax, Kmax being non-zero,
- an extended address counter (EACNT) comprising N+Kmax counting cells, N being the number of bits of the least significant address (ADL), and
- means for storing Kmax reference bits out of which K reference bits (R2-R0) represent the most significant address (RADH) allocated to the memory.

7. Memory according to claim 6, comprising a configuration register (CNFREG) for storing Kmax flags (F2-FO) corresponding by their number and their rank to the bits that the most significant address of the extended address can contain at the most, each flag having a determined logic value if one bit of corresponding rank is present in the most significant address of the extended address, such that the number of flags (F2-F0) having the determined logic value defines the number of bits present in the most significant address of the extended address.

8. Memory according to claim 6, comprising a configuration register (CNFREG) for storing a coded binary number providing information about the size of the extended memory array, and a decoding circuit supplying, based on the coded binary number, Kmax flags (F2-F0) corresponding by their number and their rank to the bits that the most significant address of the extended address can contain at the most, each flag having a determined logic value if the bit of corresponding rank is present in the most significant address of the extended address, such that the number of flags (F2-F0) having the determined logic value defines the number of bits present in the most significant address of the extended address.

9. Memory according to one of claims 6 to 8, comprising means for deactivating counting cells of the extended address counter (EACNT) according to the piece of information (K1, K0) about the number of bits that the most significant address of the extended address comprises, so that the counter only comprises N+K active counting cells.

10. Memory according to one of claims 6 to 9, wherein the means for comparing the most significant address of the extended address with the most significant address (RADH) allocated to the memory comprise a comparator (COMP) and means for inhibiting inputs of the comparator (COMP) according to the piece of information (K1, K0) about the number of bits that the most significant address of an extended address comprises, so that the comparator (COMP) only comprises K active inputs.

11. Memory according to one of claims 1 to 10, comprising:
- a ready/busy pad (RBP) that can be forced from the outside to a determined electric potential, and
- internal means (RBCT) for forcing the ready/busy pad (RBP) to the determined electric potential, during an operation of erasing or programming the integrated memory array (MA),
the memory being arranged for not executing a read or write command when the electric potential of the ready/busy pad (RBP) has the determined potential (GND).

12. Memory according to one of claims 1 to 11, comprising specific pads (IDXP0-IDXP2) enabling reference bits (R2-R0) to be configured that represent the most significant address (RADH) allocated to the memory, by applying determined electric potentials to the specific pads.

13. Extended memory array comprising a combination of at least two memories according to one of claims 1 to 12, wherein the serial inputs/outputs of each memory are interconnected.

14. Extended memory array comprising a combination of at least two memories according to claim 11, wherein the serial inputs/outputs of each memory are interconnected and the ready/busy pads of each memory are interconnected.

15. A method for producing an extended memory array addressable with an extended address (EAD) comprising a least significant address (ADL) and a most significant address (ADH), the extended memory array comprising a plurality of serial memories (MEM1-MEM4) integrated onto silicon microchips, each memory comprising a serial input/output and an integrated memory array (MA) addressable with the least significant address (ADL), the serial inputs/outputs of the memories being interconnected, a method comprising the steps of:
- providing, in each memory, means (IDXREG) for storing a most significant address (RADH) allocated to the memory within the extended memory array,
- providing, in each memory, an extended address counter (EACNT) for storing an extended address (EAD),
- allocating a most significant address (RADH) to each memory,
- applying to the memories a read or write command comprising an extended address, and
- preventing the execution of a read or write command in each memory having an allocated most significant address (RADH) that is different to the most significant address (ADH) present in the read or write command.
a method **characterized in that** the step of preventing the execution of a read command in a memory comprises allowing the memory to read its integrated memory array while preventing the data read in the integrated memory array from being applied to the serial input/output of the memory.

16. Method according to claim 15, comprising the steps of:
- providing a ready/busy pad (RBP) in each memory,
- providing, in each memory, means (RBCT, UC) for forcing the ready/busy pad (RBP) to a determined electric potential, during an operation of erasing or programming the integrated memory array (MA),
- interconnecting the ready/busy pads of the memories, and
- configure each memory for it not to execute a read or write command when the electric potential of the ready/busy pad (RBP) has the determined potential (GND).

17. Method according to claim 15, wherein each memory comprises an output buffer circuit (OUTBUF) for supplying data read in the integrated memory array (MA) to the serial input/output of the memory, and wherein the step of preventing data read in the integrated memory array from being supplied to the input/output of the memory comprises applying a blocking signal (ADMATCH, SHZ) to the output buffer circuit (OUTBUF) of the memory.

18. Method according to one of claims 15 to 17, for the production of an extended memory array capable of responding to a command for continuously reading the memory array, comprising the steps of:
- applying to the memories an extended read command comprising a start read extended address (EAD), and
- continuously incrementing or decrementing the extended address counter (EACNT) of each memory, including when the most significant address bits of the extended address are different to the most significant address (RADH) allocated to the memory, until the execution of the continuous read command stops.

19. Method according to claim 18, wherein, during the execution of a continuous read command, the integrated memory array (MA) of each memory is continuously read including when the most significant address (ADH) of the extended address is different to the most significant address (RADH) allocated to the memory.

20. Method according to one of claims 15 to 19, comprising providing, in each memory, means (CNFREG) for storing a piece of information (K1, K0) about the number K of most significant bits that the most significant address of the extended address can comprise at the most, K being a variable between 0 and Kmax, Kmax being non-zero.

21. Method according to claim 20, for the production of an extended memory array of variable size addressable by means of an extended address that can range from N bits to N+Kmax bits, without modifying the architecture of the memories making up the extended memory array, N being the number of bits of the least significant address (ADL), and comprising steps of:
- providing, in each memory, an extended address counter (EACNT) comprising N+Kmax counting cells
- providing, in each memory, means for storing Kmax reference bits, and
- allocating to each memory at least K reference bits (R2-R0) forming a most significant address (RADH).

22. Method according to claim 21, comprising deactivating counting cells of the extended address counter (EACNT) according to the piece of information (K1, K0) about the number K, so that the counter only comprises N+K active counting cells.

23. Method according to one of claims 21 and 22, in which only K reference bits (R2-R0) are compared with K most significant address bits (ADH) present in the counter, without taking into account the Kmax-K other address bits present in the counter.

24. Method according to one of claims 20 to 23, wherein the piece of information (K1, K0) about the number K is supplied to the memories in the form of a coded binary number providing information about the size of the extended memory array.

25. Method according to one of claims 15 to 24, comprising providing specific pads (IDXP0-IDXP2) in each memory and configuring the most significant address (RADH) allocated to each memory by applying determined electric potentials to the specific pads.

## Patentansprüche

1. Speicher (MEM) auf Siliziumchip, umfassend:
- einen seriellen Ein-/Ausgang und eine integrierte Speicherebene (MA),
- Mittel (IDXREG) zur Speicherung einer höherwertigen Adresse (RADH), die dem Speicher innerhalb einer erweiterten Speicherebene zugewiesen ist, die mit einer erweiterten Adresse (EAD) adressiert werden kann, die aus einer niederwertigen Adresse (ADL) und einer höherwertigen Adresse (ADH) besteht,
- einen erweiterten Adressenzähler (EACNT) zur Speicherung einer erweiterten Adresse (EAD), die am seriellen Ein-/Ausgang des Speichers empfangen wurde, und Anlegen der niederwertigen Adresse (ADL) an die integrierte Speicherebene (MA),
- Mittel (COMP) zum Vergleichen der höherwertigen Adresse (ADH) der erweiterten Adresse mit der dem Speicher zugewiesenen höherwertigen Adresse (RADH), und
- Mittel (COMP, ADMATCH, SHZ, OUTBUF, UC) zur Verhinderung der Ausführung eines Lese- oder Schreibbefehls der integrierten Speicherebene, wenn die höherwertige Adresse (ADH) der erweiterten Adresse sich von der dem Speicher zugewiesenen höherwertigen Adresse (RADH) unterscheidet,
**dadurch gekennzeichnet, dass** die Mittel zur Verhinderung der Ausführung eines Befehls zum Lesen der Speicherebene derart eingerichtet sind, dass sie den Speicher das Lesen seiner integrierten Speicherebene ausführen lassen, dabei aber verhindern, dass die in der integrierten Speicherebene gelesenen Daten an den seriellen Ein-/Ausgang des Speichers angelegt werden.

2. Speicher nach Patentanspruch 1, umfassend:
- eine Ausgangspufferschaltung (OUTBUF) zum Anlegen von in der integrierten Speicherebene (MA) gelesenen Daten an den seriellen Ein-/Ausgang des Speichers, und
- Mittel (COMP) zur Ausgabe eines Signals (ADMATCH, SHZ) zur Sperrung der Ausgangspufferschaltung, wenn sich die höherwertige Adresse (ADH) der erweiterten Adresse von der höherwertigen Adresse (RADH) unterscheidet, die dem Speicher zugeordnet ist.

3. Speicher nach Patentanspruch 2, eine Schaltung zur Zeitverzögerung (SYNCCT) zur zeitlichen Verzögerung des Anlegens des Sperrsignals (ADMATCH, SHZ) an die Ausgangspufferschaltung (OUTBUF) für den Fall umfassend, dass die Ausgangspufferschaltung in dem Augenblick, in dem das Sperrsignal in einen aktiven Wert übergeht, dabei ist, an den seriellen Ein-/Ausgang die Bits einer Information anzulegen, die in der integrierten Speicherebene (MA) gelesen wurde, bevor das Sperrsignal in den aktiven Wert übergegangen ist.

4. Speicher nach einem der Patentansprüche 1 bis 3, eine Zentraleinheit (UC) zur Ausführung eines Befehls zum fortlaufenden Lesen der erweiterten Speicherebene unter fortlaufendem Inkrementieren oder Dekrementieren des Zählers der erweiterten Adresse (EACNT), auch wenn die höherwertige Adresse (ADH) der erweiterten Adresse von der dem Speicher zugewiesenen höherwertigen Adresse (RADH) verschieden ist, bis zum Abbruch der Ausführung des Befehls zum fortlaufenden Lesen umfassend.

5. Speicher nach Patentanspruch 4, in dem die Zentraleinheit derart eingerichtet ist, dass sie während der Ausführung eines Befehls zum fortlaufenden Lesen die integrierte Speicherebene (MA) fortlaufend liest, auch wenn die höherwertige Adresse (ADH) der erweiterten Adresse von der dem Speicher zugewiesenen höherwertigen Adresse (RADH) verschieden ist.

6. Speicher nach einem der Patentansprüche 1 bis 5, umfassend:
- Mittel (CNFREG) zum Speichern einer Information (K1, K0) über eine Anzahl K an Bits, die die höherwertige Adresse der erweiterten Adresse umfasst, wobei K eine Variable ist, die zwischen 0 und Kmax beträgt, wobei Kmax ungleich Null ist,
- einen Zähler der erweiterten Adresse (EACNT), N+Kmax Zählzellen umfassend, wobei N die Anzahl an Bits der niederwertigen Adresse (ADL) ist, und
- Mittel zur Speicherung von Kmax Bezugs-Bits, von denen K Bezugsbits (R2 - R0) die dem Speicher zugeordnete höherwertige Adresse (RADH) darstellen.

7. Speicher nach Patentanspruch 6, ein Konfigurationsregister (CNFREG) zur Speicherung von Kmax Flagbits (F2 - F0) umfassend, die in Anzahl und Stellenwert den Bits entsprechen, die die höherwertige Adresse der erweiterten Adresse maximal enthalten kann, wobei jedes Flagbit einen bestimmten Wahrheitswert aufweist, wenn sich ein Bit entsprechenden Stellenwertes in der höherwertigen Adresse der erweiterten Adresse befindet, derart, dass die Anzahl an Flagbits (F2 - F0), die den bestimmten Wahrheitswert haben, die Anzahl an Bits definiert, die in der höherwertigen Adresse der erweiterten Adresse anwesend sind.

8. Speicher nach Patentanspruch 6, ein Konfigurationsregister (CNFREG) zur Speicherung einer codierten Binärzahl umfassend, das eine Angabe über die Größe der erweiterten Speicherebene macht, und eine Decodierschaltung, die aufgrund der codierten Binärzahl Kmax Flagbits (F2 - F0) liefert, die in Anzahl und Stellenwert den Bits entsprechen, die die höherwertige Adresse der erweiterten Adresse maximal enthalten kann, wobei jedes Flagbit einen bestimmten Wahrheitswert aufweist, wenn das Bit entsprechenden Stellenwerts in der höherwertigen Adresse der erweiterten Adresse anwesend ist, derart, dass die Anzahl an Flagbits (F2 - F0) mit dem bestimmten Wahrheitswert die Anzahl an Bits definiert, die in der höherwertigen Adresse der erweiterten Adresse anwesend sind.

9. Speicher nach einem der Patentansprüche 6 bis 8, Mittel zum Deaktivieren der Zählerzellen des Zählers der erweiterten Adresse (EACNT) in Abhängigkeit von der Information (K1, K0) über die Anzahl an Bits umfassend, die die höherwertige Adresse der erweiterten Adresse aufweist, derart, dass der Zähler nur N+K aktive Zählerzellen umfasst.

10. Speicher nach einem der Patentansprüche 6 bis 9, in dem die Mittel zum Vergleichen der höherwertigen Adresse der erweiterten Adresse mit der dem Speicher zugewiesenen höherwertigen Adresse (RADH) einen Vergleicher (COMP) umfassen und Mittel zur Sperrung der Eingänge des Vergleichers (COMP) in Abhängigkeit von der Information (K1, K0) über die Anzahl an Bits, die die höherwertige Adresse einer erweiterten Adresse umfasst, derart, dass der Vergleicher (COMP) nur K aktive Eingänge umfasst.

11. Speicher nach einem der Patentansprüche 1 bis 10, umfassend:
- einen Verfügbar/Besetzt-Kontakt (RBP), der von außen auf ein bestimmtes elektrisches Potential gesetzt werden kann, und
- innere Mittel (RBCT), um den Verfügbar/Besetzt-Kontakt (RBP) während eines Lösch- oder Programmiervorganges der integrierten Speicherebene (MA) auf das bestimmte elektrische Potential zu setzen,
wobei der Speicher dafür eingerichtet ist, einen Lese- oder Schreibbefehl nicht auszuführen, wenn das elektrische Potential des Verfügbar/Besetzt-Kontaktes (RBP) das bestimmte Potential (GND) aufweist.

12. Speicher nach einem der Patentansprüche 1 bis 11, spezifische Kontakte (IDXP0- IDXP2) umfassend, die erlauben, Bezugsbits (R2 - R0) zu konfigurieren, die die dem Speicher zugewiesene höherwertige Adresse (RADH) darstellen, indem bestimmte elektrische Potentiale an die spezifischen Kontakte angelegt werden.

13. Erweiterte Speicherebene, eine Kombination von mindestens zwei Speichern nach einem der Patentansprüche 1 bis 12 umfassend, in der die seriellen Ein-/Ausgänge jedes Speichers miteinander verbunden sind.

14. Erweiterte Speicherebene, eine Kombination von mindestens zwei Speichern nach Patentanspruch 11 umfassend, in der die seriellen Ein-/Ausgänge jedes Speichers miteinander verbunden sind und in der die Verfügbar/Besetzt-Kontakte jedes Speichers miteinander verbunden sind.

15. Verfahren zur Herstellung einer erweiterten Speicherebene, die mit einer erweiterten Adresse (EAD), eine niederwertige Adresse (ADL) und eine höherwertige-Adresse -(ADH) umfassend, adressiert werden kann, wobei die erweiterte Speicherebene mehrere Seriellspeicher (MEM1 - MEM4) umfasst, die auf einem Silizium-Chip integriert sind, wobei jeder Speicher einen seriellen Ein-/ Ausgang umfasst und eine integrierte Speicherebene (MA), die mit der niederwertigen Adresse (ADL) adressiert werden kann, wobei die seriellen Ein-/Ausgänge der Speicher miteinander verbunden sind, Verfahren, die folgenden Schritte umfassend:
- Bereitstellung der Mittel (IDXREG) zur Speicherung einer höherwertigen Adresse (RADH) in jedem Speicher, die dem Speicher innerhalb der erweiterten Speicherebene zugewiesen ist,
- Bereitstellung eines Zählers der erweiterten Adresse (EACNT) in jedem Speicher zur Speicherung einer erweiterten Adresse (EAD),
- Zuweisung einer höherwertigen Adresse (RADH) zu jedem Speicher,
- Erteilen eines Lese- oder Schreibbefehls, der eine erweiterte Adresse umfasst, an die Speicher, und
- Verhinderung der Ausführung eines Lese- oder Schreibbefehls in jedem Speicher mit einer zugewiesenen höherwertigen Adresse (RADH), die von der höherwertigen Adresse (ADH) verschieden ist, die sich im Lese- oder Schreibbefehl befindet, Verfahren, **dadurch gekennzeichnet, dass** der Schritt, der darin besteht, die Ausführung eines Lesebefehls in einem Speicher zu verhindern, die Tatsache umfasst, den Speicher seine integrierte Speicherebene lesen zu lassen, dabei aber zu verhindern, dass die in der integrierten Ebene gelesenen Daten an den seriellen Ein-/Ausgang des Speichers angelegt werden.

16. Verfahren nach Patentanspruch 15, die folgenden Schritte umfassend:
- Bereitstellung eines Verfügbar-/Besetzt-Kontaktes (RBP) in jedem Speicher,
- Bereitstellung von Mitteln (RBCT, UC) in jedem Speicher, um den Verfügbar-/Besetzt-Kontakt (RBP) während eines Lösch- oder Programmiervorganges der integrierten Speicherebene (MA) auf ein bestimmtes elektrisches Potential zu setzen,
- Verbinden der Verfügbar-/Besetzt-Kontakte der Speicher miteinander, und
- Konfiguration jedes Speichers derart, dass er einen Lese- oder Schreibbefehl nicht ausführt, wenn das elektrische Potential des Verfügbar-/Besetzt-Kontaktes (RBP) das bestimmte Potential (GND) aufweist.

17. Verfahren nach Patentanspruch 15, in dem jeder Speicher eine Ausgangspufferschaltung (OUTBUF) umfasst, um am seriellen Ein-/Ausgang des Speichers Daten zu liefern, die in der integrierten Speicherebene (MA) gelesen wurden, und in dem der Schritt, der darin besteht, in der integrierten Speicherebene gelesene Daten daran zu hindern, an den Ein-/Ausgang des Speichers angelegt zu werden, das Anlegen eines Sperrsignals (ADMATCH, SHZ) an die Ausgangspufferschaltung (OUTBUF) des Speichers umfasst.

18. Verfahren nach einem der Patentansprüche 15 bis 17 für die Herstellung einer erweiterten Speicherebene, die einen Befehl zum fortlaufenden Lesen der Speicherebene ausführen kann, die folgenden Schritte umfassend:
- Erteilung eines erweiterten Lesebefehls, der eine erweiterte Adresse (EAD) für den Beginn des Lesens enthält, an die Speicher und
- fortlaufendes Inkrementieren oder Dekrementieren des Zählers der erweiterten Adresse (EACNT) jedes Speichers, auch wenn die höherwertigen Adressbits der erweiterten Adresse von der dem Speicher zugewiesenen höherwertigen Adresse (RADH) verschieden sind, bis zum Abbruch der Ausführung des Befehls zum fortlaufenden Lesen.

19. Verfahren nach Patentanspruch 18, in dem die integrierte Speicherebene (MA) jedes Speichers während der Ausführung eines Befehls zum fortlaufenden Lesen fortlaufend gelesen wird, auch wenn die höherwertige Adresse (ADH) der erweiterten Adresse von der dem Speicher zugewiesenen höherwertigen Adresse (RADH verschieden ist.

20. Verfahren nach einem der Patentansprüche 15 bis 19, die Bereitstellung von Mitteln (CNFREG) zum Speichern einer Information (K1, K0) über die Zahl K von höherwertigen Bits, die die höherwertige Adresse der erweiterten Adresse maximal umfassen kann, wobei K eine Variable ist, die zwischen 0 und Kmax beträgt, wobei Kmax ungleich Null ist, umfassend.

21. Verfahren nach Patentanspruch 20 zur Herstellung einer erweiterten Speicherebene variabler Größe, die mit Hilfe einer erweiterten Adresse von zwischen N Bits und N+Kmax Bits adressiert werden kann, ohne die Architektur der Speicher zu ändern, die die erweiterte Speicherebene bilden, wobei N die Anzahl an Bits der niederwertigen Adresse (ADL) ist, die folgenden Schritte umfassend:
- Bereitstellung eines Zählers der erweiterten Adresse (EACNT), N+Kmax Zählzellen umfassend, in jedem Speicher,
- Bereitstellung von Mitteln zur Speicherung von Kmax Bezugs-Bits in jedem Speicher, und
- Zuweisen zu jedem Speicher von mindestens K Bezugsbits (R2 - R0) die eine höherwertige Adresse (RADH) bilden.

22. Verfahren nach Patentanspruch 21, das Deaktivieren der Zählerzellen des Zählers der erweiterten Adresse (EACNT) in Abhängigkeit von der Information (K1, K0) über die Zahl K umfassend, derart, dass der Zähler nur N+K aktive Zählerzellen umfasst.

23. Verfahren nach einem der Patentansprüche 21 und 22, in dem nur K Bezugsbits (R2 - R0) mit K Bits der höherwertigen Adresse (ADH) verglichen werden, die sich im Zähler befinden, ohne die Kmax - K anderen Adressbits zu berücksichtigen, die sich im Zähler befinden.

24. Verfahren nach einem der Patentansprüche 20 bis 23, in dem die Information (K1, K0) über die Zahl K den Speichern in Form einer codierten Binärzahl geliefert wird, die eine Angabe über die Größe der erweiterten Speicherebene macht.

25. Verfahren nach einem der Patentansprüche 15 bis 24, das Bereitstellen spezifischer Kontakte (IDXPO - IDXP2) in jedem Speicher umfassend und das Konfigurieren der jedem Speicher zugewiesenen höherwertigen Adresse durch Anlegen bestimmter elektrischer Potentiale an die spezifischen Kontakte.
